# EUROPEAN PATENT APPLICATION

(11) **EP 0 614 101 A2**
(43) Date of publication of application: **07.09.1994**
(21) Application number: 94101555.4
(22) Date of filing: 02.02.1994
(51) Int. Cl.: G02B 26/08, G09F 9/37

(54) **Optical deflector and method of manufacturing the same**

(71) Applicant: CANON KABUSHIKI KAISHA, Tokyo (JP)
(72) Inventor: Yagi, Takayuki, c/o CANON KABUSHIKI KAISHA, Tokyo 146 (JP); Suda, Shigeyuki, c/o CANON KABUSHIKI KAISHA, Tokyo 146 (JP); Takagi, Hiroshi, c/o CANON KABUSHIKI KAISHA, Tokyo 146 (JP); Mitsutake, Hideaki, c/o CANON KABUSHIKI KAISHA, Tokyo 146 (JP); Yamamoto, Tomoko, c/o CANON KABUSHIKI KAISHA, Tokyo 146 (JP)
(74) Representative: Tiedtke, Harro, Dipl.-Ing.

(57) **Abstract**

In an optical deflector, a substrate (1) has an upper surface with a stationary electrode. A mechanically movable portion (11) is formed on the substrate through a space. The mechanically movable portion consists of an electric conductor and has an optical deflecting plate. A voltage is applied to the stationary electrode. A groove for receiving a free end of the optical deflecting plate upon displacement of the mechanically movable portion is formed in the substrate. The mechanically movable portion has beams (11b) for supporting the optical deflecting plate.

## Description

### BACKGROUND OF THE INVENTION

### Field of the Invention

The present invention relates to an optical deflector for performing optical control using a mechanically movable portion, a method of manufacturing the same, and an image display device using this optical deflector.

### Related Background Art

Most of the existing optical deflectors use, for example, a mechanical stop used for-light amount control in a camera or the like, a solid-state optical shutter (Electrophotography, Vol. 30, No. 4, 1991, pp. 447-494) for controlling, within a small area, the amount of light radiated from a rear surface using an electrooptical effect of a liquid crystal cell or ferroelectric material (e.g., a PLZT), and the like. Of these conventional examples, the optical shutter has been considered for a variety of applications such as an optical deflector in an optical switch or the like used for switching an optical fiber transmission line or terminal device, an optical printer head in an electrophotographic printer as an image display device using a one-dimensional optical shutter array, and a liquid crystal display using a two-dimensional liquid crystal cell array.

The mechanical optical deflector as an optical element for optical communication such as an optical switch can perform deflection and light shielding independently of the wavelength of light. For this reason, the mechanical optical deflector is useful when a multiple wavelength light source is used or a light source has variations in wavelength. However, the mechanical optical deflector is inferior to the solid-state optical shutter in response speed, compactness, array formation, and the like. Therefore, the application fields of the mechanical optical shutters are limited.

A micro-mechanical member having a compact movable mechanism using a semiconductor photolithographic process has recently been taken into consideration in accordance with micro-mechanical techniques. Such a micro-mechanical member can easily form a low-cost array in accordance with the semiconductor photolithographic process and is expected to have a high response speed in a compact arrangement. Examples of the optical deflector as a mechanical optical element using the micro-mechanical techniques are a torsional scanning mirror using silicon, proposed by K.E. Petersen et al. (IBM J. RES, DEVELOP., VOL. 24, NO. 5, 9, 1980, pp. 631-637), a display device (U.S. Pat. No. 4,229,732), and a spatial optical deflector using an Al thin film, proposed by L.J. Hornbeck (Japanese Laid-Open Patent Application No. 2-8812).

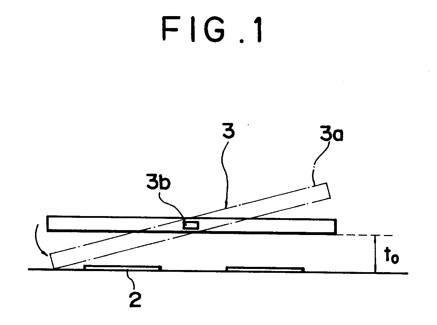

In such a mechanical optical element, as shown in Fig. 1, a mechanically movable portion 3 comprises a mirror 3a as an electric conductor serving as an optical deflector and beams 3b for supporting the mirror 3a. A drive voltage is applied between the mirror 3a and stationary electrodes 2 to generate an electrostatic attraction, thereby causing a torsion moment to act on the beams 3b to rotate the mirror 3a. The deflection angle of the mirror 3a is thus changed. A maximum deflection angle of the mirror is uniquely defined by a spatial distance (t₀) between the mirror and the substrate (Fig. 1; a conventional optical deflector). In this optical deflector, a larger deflection angle means a better optical deflector, but a larger spatial distance must be set to obtain a larger deflection angle. When a plurality of optical deflectors are arranged to obtain an optical printer head in an electrophotographic printer or a display device in a display, it is preferable to increase the deflection angle while minimizing the spatial arrangement with an optical system so as to obtain a compact display device. Another important factor for obtaining a compact arrangement is the use of an IC of drive circuits for independently driving the optical deflectors, i.e., integration of the drive circuits. In addition, to reduce the cost of a peripheral circuit, an IC is used to reduce the power consumption. In the torsional scanning mirror proposed by Petersen et al., bonding alignment and manufacturing handling pose a problem for a compact arrangement since a glass substrate is bonded to Si having a mirror and beams for supporting the mirror. Therefore, it is difficult to apply this torsional scanning mirror to the printer or the display device for the display.

In the display device proposed by Petersen et al. and the spatial optical modulator proposed by Hornbeck, which can be easily integrated, an increase in spatial distance results in an increase in distance between the stationary electrode and the mirror serving as an electric conductor. For this reason, the moment for rotating the mirror must be increased, and hence the drive voltage must be increased. To the contrary, in order to decrease the drive voltage, the spatial distance and hence the deflection angle must be reduced. When a mechanical optical deflector which can be integrated is used in a display device, a decrease in drive voltage contradicts with a large deflection angle.

In the conventional mechanical optical element, the mirror warps due to the internal stress of a film which is a thin film made of Al or the like and serves as the mirror. For this reason, the deflection surface cannot be a flat surface, and the amount of deflected light in a desired direction decreases, resulting in inconvenience. In the spatial optical modulator (Japanese Laid-Open Patent Application No. 2-8812), a spacer between a mirror and a drive electrode is formed by a photoresist. In coating the photoresist, the photoresist is diluted with an organic solvent to an appropriate viscosity to cause variations in viscosities, thereby causing variations in thicknesses of spacers. The variations in thicknesses then cause shifts in deflection angles, thus reducing the manufacturing yield. Therefore, process control must be sufficiently performed to manufacture thin films without warpage with good reproducibility.

When an optical deflector is used in an image display device, and especially a television set, gradation display (8 bits; about 256 gradation levels) is indispensable. However, the above-mentioned spatial optical deflector (Japanese Laid-Open Patent Application No. 2-8812) basically performs a binary display and it is difficult for the spatial optical deflector to stably perform a multi-gradation display. For this reason, an area modulation scheme for expressing gradation levels by an area ratio in combination with the spatial optical modulator or a pulse width modulation scheme for expressing the gradation levels by the number of times by which the spatial optical modulator is modulated for a predetermined pulse duration can be considered as a multi-gradation display means. In the area modulation scheme, to perform an 8-bit (256 gradation levels) gradation display, 256 unit pixels for the binary display must be grouped into one pixel, and the display image has a low spatial power. That is, when one spatial optical modulator is defined as one unit element, 16 unit elements constitute one pixel. When the size of one unit element is 10 µm², one pixel has a size of 160 µm². In this case, if an image display device has a width of 3", it has a resolution of only about 500 pixels. In order to obtain a higher resolution, the image display device must have a larger size. When this image display device is to be manufactured using the semiconductor photolithographic process, the number of image display devices per substrate (per Si wafer) is reduced to decrease the yield and degrade productivity, resulting in a high-cost image display device.

In the pulse width modulation scheme, to perform an 8-bit (256 gradation levels) gradation display, one frame must be scanned within 130 µs (1 = 1/30/256) to scan a frame count of 30 Hz. For example, if an image display device has 1,000 scanning lines, the scanning time of each scanning time must fall within 0.1 µs. In shift register transfer required for transferring data of one scanning line, if the number of pixels per scanning line is 2,000, the shift time per cycle falls within 0.06 ns. For this reason, the drive frequency of the shift register becomes about 16 GHz, and a drive means for dividing the screen of the image display device is required to overload the drive system, thereby increasing the cost of the drive peripheral circuit of the image display device, and hence resulting in a high-cost image display device. For this reason, when an optical deflector is applied to an image display device to obtain a compact image display device having a drive-system whose load is small, the gradation expression for each pixel is preferably performed by changing the amount of deflected light from each optical deflector.

### SUMMARY OF THE INVENTION

The present invention has been made in consideration of the conventional problems described above, and has as its object to provide a compact light reflection type mechanical optical deflector which can be easily integrated and formed into an array, can reduce the drive voltage, and can obtain a large deflection angle, a method of manufacturing this optical deflector, and an image display device using this optical deflector.

In order to achieve the above object of the present invention, there is provided an optical deflector comprising a substrate having an upper surface with at least one stationary electrode being formed thereon, and a mechanically movable portion formed on the substrate through a space, the stationary electrode being applied with a voltage to spatially displace the mechanically movable portion toward the stationary electrode, thereby deflecting light incident on the substrate, characterized in that the mechanically movable portion comprises an electric conductor thin film and an optical deflecting plate, and a groove for receiving at least one free end of the optical deflecting plate upon displacement of the mechanically movable portion is formed in the substrate, characterized in that the mechanically movable portion comprises an optical deflecting plate and beams which support the optical deflecting plate and rotates with a torsion, the groove is a V-groove, and at least one of the stationary electrodes is formed at one side of the V-groove, characterized in that the stationary electrode is disposed at a portion on a substrate surface other than a groove below the optical deflecting plate, characterized in that a dielectric thin film is formed on the stationary electrode, and the optical deflecting plate is in surface contact with the surface of the dielectric thin film formed on the stationary electrode, characterized in that the mechanically movable portion comprises a support portion formed on a portion of substrate surface other than a groove through a contact portion, and a cantilevered plate, the cantilevered plate is an optical deflecting plate, or characterized in that the mechanically movable portion comprises a flexible plate, an optical deflecting plate formed on one end face serving as a free end of the flexible plate, and a contact portion for fixing the other end face of the flexible plate on a portion of substrate surface other than a groove, and a space is constituted by only a groove. The electric conductor thin film constituting the mechanically movable portion may be a metal thin film.

According to the present invention, there is provided a method of manufacturing an optical deflector on a substrate using a thin film forming method, characterized by comprising the steps of forming a groove in the substrate, forming a stationary electrode on the substrate having the groove, burying the groove with a burying material and flattening the resultant surface, forming a mechanically movable portion having the optical deflecting plate on the flattened substrate, and removing the burying material.

There is also provided an image display device, comprising a plurality of optical deflectors each as described above, and displacing means for displaying each optical deflector independently of the remaining optical deflectors, thereby displaying an image.

In the optical deflector having the above arrangement described above, when a voltage is applied to the stationary electrode formed on the substrate, an electrostatic attraction force is generated between the stationary electrode and the optical deflector arranged in the mechanically movable portion formed on the substrate, and the optical deflector is attracted toward the stationary electrode and is thus spatially displaced. At this time, the optical deflecting plate has a large spatial displacement upon driving the mechanically movable portion because the groove for receiving at least one free end of the optical deflecting plate is formed in the substrate. Therefore, light incident on the substrate can be deflected at a larger angle.

Since the groove for receiving at least one free end of the optical deflecting plate is formed in the substrate, unlike the conventional example, a large spatial distance need not be formed to obtain a large deflection angle between the stationary electrode and the mechanically movable portion, thereby reducing power consumption.

The present invention has been made in consideration of the conventional drawbacks described above, and has as its object to provide an optical deflector capable of realizing the following points and an image display device using this optical deflector:
(1) a compact light reflection type mechanical optical deflector which can be easily formed into an array;
(2) an optical deflector having a mirror with a sufficient degree of flatness regardless of the presence/absence of the stress of a thin film and capable of increasing the manufacturing yield;
(3) an optical deflector capable of keeping the deflection angle constant regardless of the thickness of a spacer; and
(4) an image display device in which a plurality of optical deflectors each realizing the above contents are arranged on a plane to obtain an image display device, and the respective optical deflectors are independently controlled, thereby obtaining the area gradation of an image to be displayed.

In order to achieve the above object, there is provided an optical deflector comprising a flat plate-like stationary electrode, a dielectric layer formed to flatly cover one surface of the stationary electrode, a mirror member constituted by a thin, flat metal plate having elasticity, a support member for supporting one end of the mirror member to oppose the stationary electrode covered with the dielectric layer at a predetermined spatial distance when a voltage is not applied between the stationary electrode and the mirror member, a light source for obliquely radiating a light beam onto the flat surface of the stationary electrode, and a voltage application control unit for, when a desired amount of reflected light is required on a light-receiving portion, applying a voltage corresponding to the desired amount of reflected light between the stationary electrode and the mirror member, attracting the mirror member toward the stationary electrode, bringing the mirror member into tight contact with the dielectric layer from a free end side by an area corresponding to the desired amount of reflected light, and reflecting and deflecting light toward the light-receiving portion in an amount proportional to the area by which the mirror member is in tight contact with the dielectric layer. The dielectric layer may be formed on a surface not opposing the stationary electrode, but on a surface of the mirror member which opposes the stationary electrode.

The image display device according to the present invention has the plurality of optical deflectors arranged on a plane and can drive the voltage application control unit for independently controlling the respective optical deflectors to display an image using light reflected by each optical deflector.

In the optical deflector having the above arrangement according to the present invention, she voltage application control unit applies a voltage corresponding to a desired amount of reflected light to attract the mirror member toward the stationary electrode. The mirror member is brought into tight contact with the dielectric layer from the free end side by an area corresponding to the desired amount of reflected light. Since the light beam becomes incident on the mirror member in tight contact with the dielectric layer, light is reflected and deflected toward-the light-receiving portion in an amount proportional to the area in which the mirror member is in tight contact with the dielectric layer. In the image display device having the plurality of optical deflectors, the respective optical deflectors are independently controlled by the voltage application control unit, and the amount of light reflected by each optical deflector is changed. Therefore, the gradation of an image to be displayed can be freely changed.

### BRIEF DESCRIPTION OF THE DRAWINGS

Fig. 1 is a view showing a conventional optical deflector;
Fig. 2 is a plan view showing the first embodiment of an optical deflector according to the present invention;
Fig. 3 is a sectional view of the optical deflector along the line A - A in Fig. 2;
Fig. 4 is a view for explaining the principle of operation of the first embodiment of the optical deflector according to the present invention;
Fig. 5 is a view for explaining a deflection operation of the first embodiment of the present invention;
Fig. 6 is a view showing a method of forming a groove in an optical deflector according to the present invention;
Fig. 7 is a view showing another method of forming a groove in an optical deflector according to the present invention;
Fig. 8 is a view showing still another method of forming a groove in an optical deflector according to the present invention;
Figs. 9A to 9F are sectional views showing the steps in manufacturing the first embodiment of the optical deflector according to the present invention;
Fig. 10 is a view showing a structure in which stationary electrodes of the first embodiment of the optical deflector according to the present invention are arranged on a substrate surface;
Fig. 11 is a view showing a structure in which the stationary electrodes of the first embodiment of the optical deflector according to the present invention are arranged on a substrate and a groove with a rectangular section is formed;
Fig. 12 is a view showing another structure in which the stationary electrodes of the first embodiment of the optical deflector according to the present invention are arranged on a substrate and a groove with a rectangular section is formed;
Fig. 13 is a perspective view for explaining another structure of a support portion of the first embodiment of the optical deflector according to the present invention;
Fig. 14 is a sectional view for explaining a structure of the second embodiment of an optical deflector according to the present invention;
Fig. 15 is a sectional view for explaining another structure of the second embodiment according to the present invention;
Figs. 16A to 16G are sectional views for explaining the steps in manufacturing the second embodiment according to the present invention;
Fig. 17 is a perspective view for explaining a structure of the third embodiment of an optical deflector according to the present invention;
Fig. 18 is a sectional view showing the optical deflector shown in Fig. 17;
Figs. 19A to 19F are sectional views for explaining the steps in manufacturing the third embodiment of the optical deflector according to the present invention;
Fig. 20 is a perspective view for explaining a structure of the fourth embodiment of an optical deflector according to the present invention;
Fig. 21 is a sectional view showing the optical deflector shown in Fig. 20;
Figs. 22A to 22G are sectional views for explaining the steps in manufacturing the fourth embodiment of the optical deflector according to the present invention;
Fig. 23 is a view showing an image display device in which the optical deflectors constituting the first embodiment shown in Fig. 13 are arrayed on a single substrate to obtain a micro-mirror array;
Fig. 24 is a view showing an application of the image display device shown in Fig. 23 to electrostatic printing;
Fig. 25 is a plan view showing a two-dimensional array of the image display device shown in Fig. 23;
Fig. 26 is a plan view showing an image display device in which the optical deflectors each shown in Fig. 17 or 20 are two-dimensionally arrayed;
Fig. 27 is a view showing an optical system obtained when the image display device shown in Fig. 25 is applied to a projection display;
Fig. 28 is a view showing a color filter for realizing the image display device in Fig. 27 as a color image display device;
Fig. 29 is a view showing an optical system using the color filter shown in Fig. 28;
Fig. 30 is a plan view showing the fifth embodiment of an optical deflector according to the present invention;
Fig. 31 is a sectional view showing the optical deflector along the line B - B in Fig. 30;
Fig. 32 is a view showing a principle operation of the embodiment shown in Fig. 30;
Fig. 33 is a view showing a deflection operation of the embodiment shown in Fig. 30;
Figs. 34A to 34F are sectional views showing the steps in manufacturing the optical deflector of the embodiment shown in Fig. 30;
Fig. 35 is a graph showing the operation of the embodiment shown in Fig. 30;
Fig. 36 is a perspective view showing the sixth embodiment of an optical deflector according to the present invention;
Fig. 37 is a plan view showing the seventh embodiment of an optical deflector according to the present invention;
Fig. 38 is a sectional view showing the optical deflector along the line C - C in Fig. 37;
Fig. 39 is a view showing a method of applying a voltage in the embodiment shown in Fig. 37;
Figs. 40A to 40F are sectional views showing the steps in manufacturing the optical deflector of the embodiment shown in Fig. 37;
Fig. 41 is a plan view showing the eighth embodiment of an optical deflector according to the present invention;
Fig. 42 is a sectional view of the optical deflector along the line D - D in Fig. 41;
Fig. 43 is a perspective view showing a method of applying a voltage to the embodiment shown in Fig. 41;
Figs. 44A to 44F are sectional views for explaining the steps in manufacturing the optical deflector of the embodiment shown in Fig. 41;
Fig. 45 is a perspective view showing the ninth embodiment of an optical deflector according to the present invention;
Figs. 46A to 46F are sectional views for explaining the steps in manufacturing the optical deflector of the embodiment shown in Fig. 45;
Fig. 47 is a perspective view showing the tenth embodiment of an optical deflector according to the present invention;
Fig. 48 is a side view of the embodiment in Fig. 47;
Fig. 49 is a plan view showing an embodiment of an image display device in which the optical deflectors shown in Fig. 36 are one-dimentionally arrayed according to the present invention;
Fig. 50 is a plan view showing an image display device in which the optical deflectors each shown in Fig. 36 are two-dimensionally arrayed;
Fig. 51 is a plan view showing another embodiment of an image display device in which the optical deflectors shown in Fig. 37 are one-dimentionally arrayed according to the present invention;
Fig. 52 is a view showing an image display device in which the optical deflectors each shown in Fig. 37 are two-dimensionally arrayed;
Fig. 53 is a plan view showing still another embodiment of an image display device in which the optical deflectors shown in Fig. 45 are one-dimentionally arrayed according to the present invention;
Fig. 54 is a view showing an image display device in which the optical deflectors each shown in Fig. 45 are two-dimensionally arrayed; and
Fig. 55 is a view showing an image display device in which the optical deflectors each shown in Fig. 47 are two-dimensionally arrayed.

### DETAILED DESCRIPTION OF THE PREFERRED EMBODIMENTS

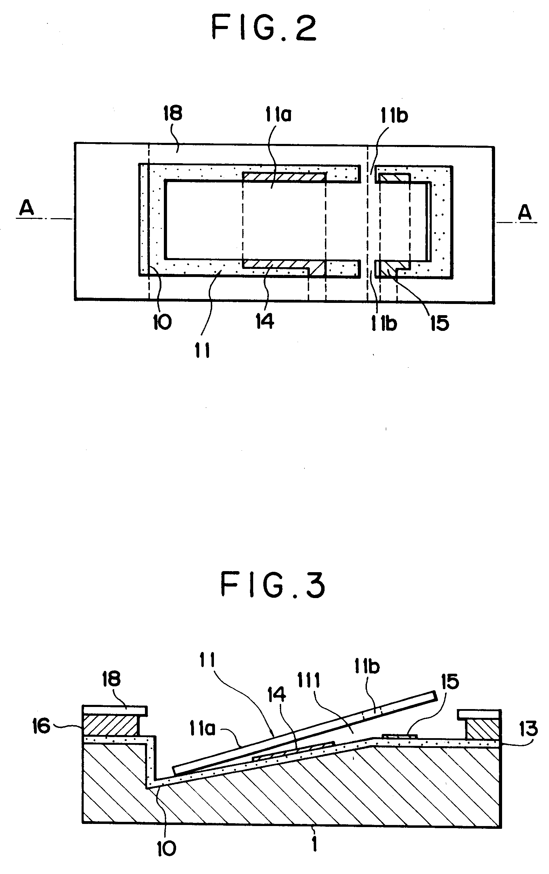

Preferred embodiments of optical deflectors, their manufacturing methods, and image display devices using the optical defectors according to the present invention will be described in detail with reference to Figs. 2 to 29.

Fig. 2 is a plan view showing the first embodiment of an optical deflector according to the present invention, and Fig. 3 is a sectional view of the optical deflector along the line A - A in Fig. 2.

As shown in Fig. 3, the optical deflector according to the present invention has a substrate 1 having an upper surface with a V-groove 10, and stationary electrodes 14 and 15 are formed at predetermined positions on the upper surface of the substrate 1 through an insulating layer 13. A mechanically movable portion 11 supported by a support portion 18 shown in Fig. 2 is formed on the upper surface of the insulating layer 13 through spacers 16 at two end faces of the insulating layer 13. A space 111 is formed between the mechanically movable portion 11 and the upper surface of the insulating layer 13 by the spacers 16. The mechanically movable portion 11 comprise a mirror 11a serving as an optical deflecting plate and beams 11b formed at two ends of the mirror 11a. As shown in Fig. 2, one end of each beam 11b is supported by the support portion 18. The support portion 18, the beams 11b, and the mirror 11a are made of electric conductor thin films.

The stationary electrode 14 is formed on the insulating layer 13 such that it will not be brought into contact with the stationary electrode 14 and the mirror 11a even if the free end of the mirror 11a is brought into contact with the insulating layer 13 during movement of the mirror 11a. The stationary electrode 15 is formed such that it will not be brought into contact with the mirror 11a even if the other free end of the mirror 11a is brought into contact with the insulating layer 13. When the groove 10 is formed as described above, a large deflection angle can be obtained, and at the same time, the distances between the stationary electrode 14 and the mirror 11a and between the stationary electrode 15 and the mirror 11a can be set small during movement of the mirror 11a.

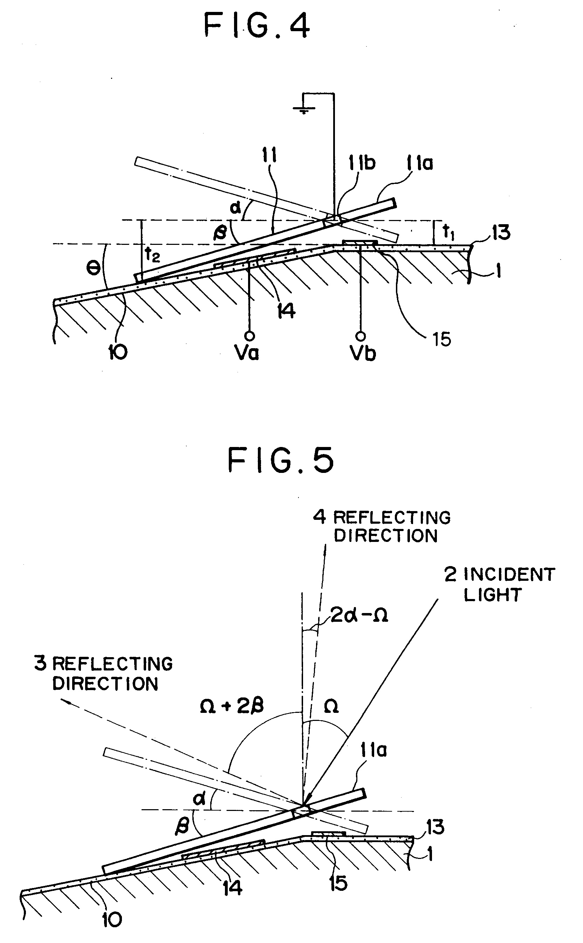

Fig. 4 is a view for explaining the principle of operation of the first embodiment of the optical deflector according to the present invention. Although not shown in Fig. 4, the mirror 11a is electrically grounded to the support portion 18 (Fig. 2) through the beams 11b. When voltages are not applied to the stationary electrodes 14 and 15, the mirror 11a is kept stopped on a plane parallel to the upper surface of the insulating layer 13 at a distance t₁ therefrom. At this time, when a voltage Vₐ is applied to the stationary electrode 14, the mirror 11a is attracted toward the stationary electrode 14 to distort the beams 11b, so that one free end of the mirror 11a is brought into contact with the groove 10 (Fig. 3) formed in the substrate. At this time, the stop position of the grounded mirror 11a and the position of the mirror 11a which is in contact with the groove 10 form an angle β (at this time, the spatial distance between the groove and the stop position of the grounded mirror 11a is t₂). Voltage application to the stationary electrode 14 is stopped, and a voltage is then applied to the stationary electrode 15. In this case, the other free end of the mirror 11a is brought into contact with the insulating layer 13, and the stop position of the grounded mirror 11a and the position of the mirror 11a when in contact with the groove 10 form an angle α. In this manner, the rotation angle of the mirror 11a about the beams 11b is determined, and the light deflection angle upon radiation of light on the mirror 11a can be changed within the range of (α + β). The deflection angles α and β are uniquely determined by the spatial distance t₁ between the mirror 11a and the insulating layer 13 and the layout of the V-groove 10 (Fig. 3).

In this embodiment, the mirror 11a is asymmetrically cantilevered with respect to the beams 11b. Although a symmetrical layout may be employed, a large deflection angle α can be set when the asymmetrical layout of the mirror 11a with respect to the beams 11b is employed. When the mirror 11a is set symmetrical with the beams 11b, it is possible to obtain a large deflection angle α when a groove is formed on the side of the stationary electrode 15. Alternatively, an angle Θ formed between the groove and the substrate may be set large to increase the deflection angle β.

Fig. 5 is a view showing the deflection operation of the first embodiment of the optical deflector according to the present invention. Referring to Fig. 5, incident light 2 incident on the substrate 1 at an angle Ω with respect to the perpendicular line to the substrate 1 is deflected in a reflecting direction 4 (indicated by a dotted line) upon application of a voltage to the stationary electrode 15. Voltage application to the stationary electrode 15 is stopped, and a voltage is then applied to the stationary electrode 14 to deflect the incident light 2 in a reflecting direction 3 (indicated by a dotted line). That is, a maximum deflection angle of (2α + 2β) can be obtained. In the optical deflector according to the present invention, as compared with an arrangement in which a groove for allowing contact of the free end of the mirror with one side of the V-groove, even if the height (corresponding to the distance t₁ in Fig. 4) of the spacer 16 varies, variations in spatial distance can be corrected by the inclination of the groove, thereby reducing the error of the deflection angle.

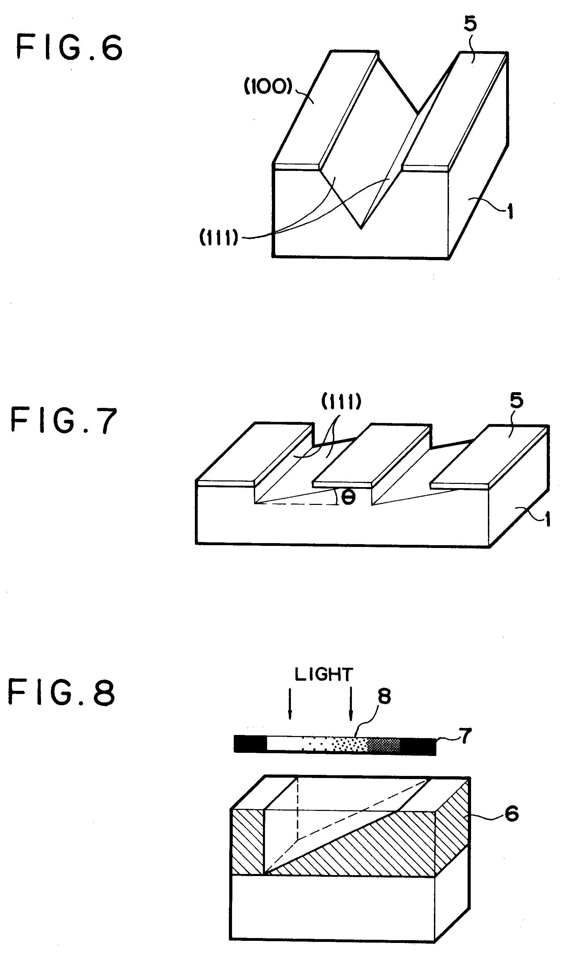

A method of manufacturing the optical deflector according to the present invention will be described with reference to Figs. 6 to 8. Figs. 6 to 8 are views showing a method of forming the groove in the optical deflector according to the present invention.

In formation of a groove, and particularly a V-groove, it is possible to form a V-groove using anisotropic etching (D. M. Allen et al., "Anisotropic Etching of Silicon", IEEE Proc., Vol. 130, Pt. I, No. 2, 1983, pp. 49-56) which utilizes an etching rate difference depending on the Si crystal face. Examples of an etching solution for anisotropic etching are an aqueous alkali metal hydroxide solution (e.g., KOH, NaOH, or CsOH), an aqueous amine solution (hydrazine or ethylene diamine, and the like). When contamination of a substrate by metal ions is taken into consideration, an aqueous etching solution (O. Tabata et al., "Anisotropic Etching of Silicon with Quaternary Ammoniumhydroxide Solutions", TECHNICAL DIGEST OF THE 9TH SENSOR SYMPOSIUM, 1990, pp. 15-18) such as TEAH (tetraethyl ammoniumhydroxide), or TMAH (tetramethyl ammoniumhydroxide) which does not contain metal ions is preferable. As shown in Fig. 6, an etching mask 5 having a resistance to etching, such as a silicon oxide film, a silicon nitride film, or a metal film which is patterned by photolithography into an appropriate shape is formed on the Si substrate 1 having a (100) plane on its upper surface, and anisotropic etching is performed to obtain a V-groove. Alternatively, as shown in Fig. 7, the surface of a V-groove is a (111) plane, the surface of an Si substrate 1 is cut at an angle Θ with respect to the (111) plane, and the cut surface is used to perform anisotropic etching, thereby obtaining a long-side V-groove with high precision.

As another V-groove formation method, oblique ion etching for forming a groove in a substrate utilizing a difference between the etching rates of a photoresist mask and a substrate is available (S. Matsui et al., Jpn. J. Appl. Phys., Vol. 19, pp. L126-L128, 1980 or Sano et al., OYOBUTURI, Vol. 48, No. 6, pp. 539-544, 1979). According to this method, a V-groove having a desired angle can be manufactured regardless of the substrate crystal face. As still another V-groove formation method, an etch-back method (Y. Homma et al., J. Electrochem. Soc., Vol. 126, pp 1531-1533) is available as one of the techniques for flattening an insulating layer in a semiconductor planar process in which a photoresist is exposed and developed using the photolithographic process to form a V-groove in the photoresist, and then the V-groove formed in the photoresist is transferred to the substrate by ion etching.

As a method of forming a V-groove by developing a photoresist, a method of forming a micro-structure using a halftone mask proposed by W. E. Feely is used ("MICRO-STRUCTURES", IEEE SOLID-STATE SENSOR AND ACTUATOR workshop, Hilton Head Island, June 6-9, 1988, pp. 13-15). This method is schematically shown in Fig. 8. Light is radiated on a photomask 7, part of which serves as a halftone portion 8, and a photoresist 6 is exposed to form a V-groove. In Fig. 8, the halftone portion 8 has four gradation levels. To obtain a V-groove, the amount of light transmitted through the halftone portion 8 must smoothly change. In this case, the photoresist 6 is a positive photoresist.

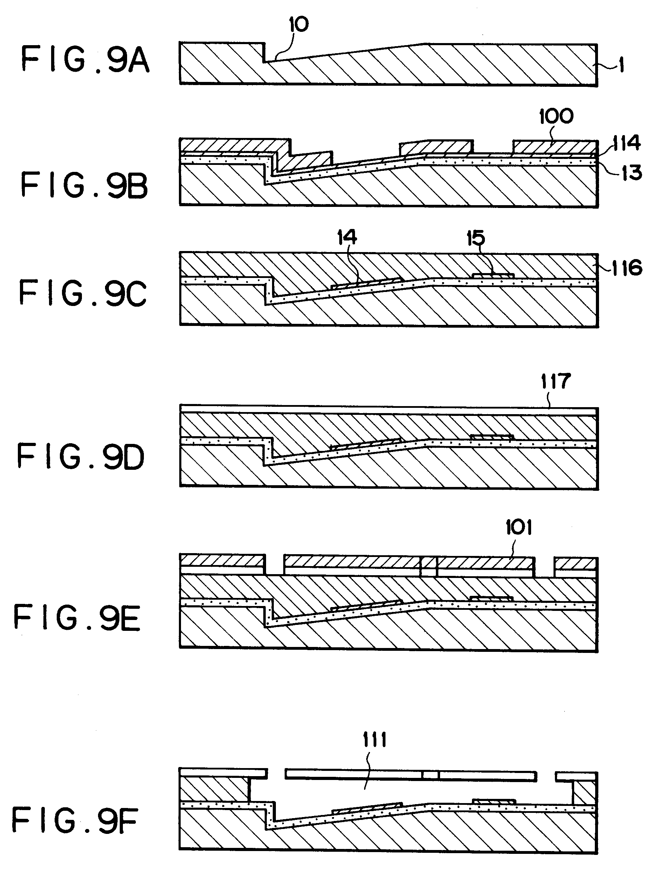

The steps in manufacturing the first embodiment of the optical deflector according to the present invention will be described below. Figs. 9A to 9F show the steps in manufacturing the first embodiment of the optical deflector according to the present invention.

A V-groove 10 was formed in an Si substrate 1 by anisotropic etching (Fig. 9A). At this time, the substrate had an angle Θ of 19.4°, which was described with reference to Fig. 7. The (111) plane as one side of the V-groove was a plane perpendicular to the surface of the substrate 1, and the maximum depth of the groove was 3.5 µm.

As shown in Fig. 9B, the Si substrate 1 having the V-groove 10 was loaded in an oxidation furnace heated to 1,100°C, and a gas mixture of oxygen and hydrogen was supplied thereto to form a 1-µm thick thermal silicon oxide film serving as an insulating layer 13. A 1,500-Å thick polysilicon film serving as stationary electrodes 14 and 15 was formed by low-pressure CVD (LPCVD). Phosphorus (P) was ion-implanted at a dose of 1 x 10¹⁶ (ions/cm²) in accordance with the ion-implantation method and was diffused in a nitrogen atmosphere at 1,100°C for an hour. As a result, the sheet resistance of each polysilicon film was 12 Ω/□. A photoresist 100 was coated on a polysilicon film 114 and patterned by the photolithographic process for performing exposure and development, and a polysilicon pattern was formed by an aqueous solution mixture of hydrofluoric acid and nitric acid. The resist pattern was removed to form the stationary electrodes 14 and 15 shown in Fig. 9C.

The groove 10 was then buried and flattened, as shown in Fig. 9C, to form spacers 16. A photoresist 116 was coated to realize a method of simultaneously burying the groove 10 and forming the spacers 16 (Fig. 3). The photoresist 116 was formed such that a photoresist (AZ1350J; tradename) available from Hoechst was diluted with a solvent to obtain an appropriate viscosity and the resultant solution was repeatedly coated until a flat surface was obtained. Thereafter, the photoresist was etched back using CF₄ gas in accordance with reactive ion etching (RIE) until the thickness (corresponding to the distance t₁ in Fig. 4) of the spacer became 0.5 µm.

As for an electric conductor thin film serving as a mirror 11a and beams 11b (Fig. 3) subjected to torsional rotation, aluminum (Al) was sputtered using argon in accordance with the sputtering method using argon, as shown in Fig. 9D, to deposit a 3,000-Å thick Al thin film. The temperature of the substrate holder during sputtering was set at 5°C to suppress thermal stress during the film formation.

As shown in Fig. 9E, a photoresist 101 was coated on the resultant structure and patterned in accordance with the photolithographic process, and Al was patterned by RIE using an etching gas mixture of BCl₃ and Cl₂.

The photoresist 101 on an Al film 117 and the photoresist 116 under the mirror 11a and the beams 11b were etched and removed by RIE using an oxygen plasma to form a space 111. At this time, the etching conditions were set such that oxygen was used at 100 ccm or more and the gas pressure during etching was 20 Pa or more, thereby establishing conditions for obtaining a large side-etch amount. An optical deflector shown in Fig. 9F was obtained by the above steps.

In the resultant optical deflector, a longer free end of the mirror 11a cantilevered by the beams 11b (Fig. 2) had a length of 9.5 µm and a width of 10 µm. When a voltage of 30 V was applied to the stationary electrode 14, the free end of the mirror 11a was brought into contact with the inclined surface of the groove. At this time, the angle formed between the mirror 11a and the substrate 1 was 20.6° (the angle β in Fig. 4). The space was formed by the spacers in the steps from Fig. 9B without forming the V-groove 10 in the substrate 1, and a voltage of 40 V was required to allow contact of the mirror 11a with the substrate 1. In the first embodiment, the stationary electrode was formed at one side of the V-groove formed in the substrate to shorten the spatial distance between the mirror and each stationary electrode and increasing the electrostatic attraction force, thereby realizing a low-voltage arrangement. In addition, in order to reduce the applied voltage, the thickness of the Al film in Fig. 9D can be reduced. As another method, only the beams may be made thin, and the mirror can be driven by a drive circuit formed on the semiconductor substrate. The resultant optical deflector can be a compact, lightweight deflector array.

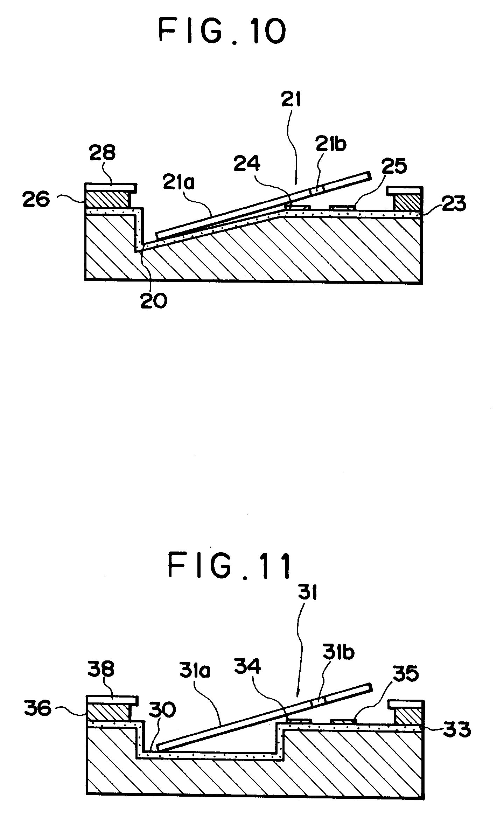

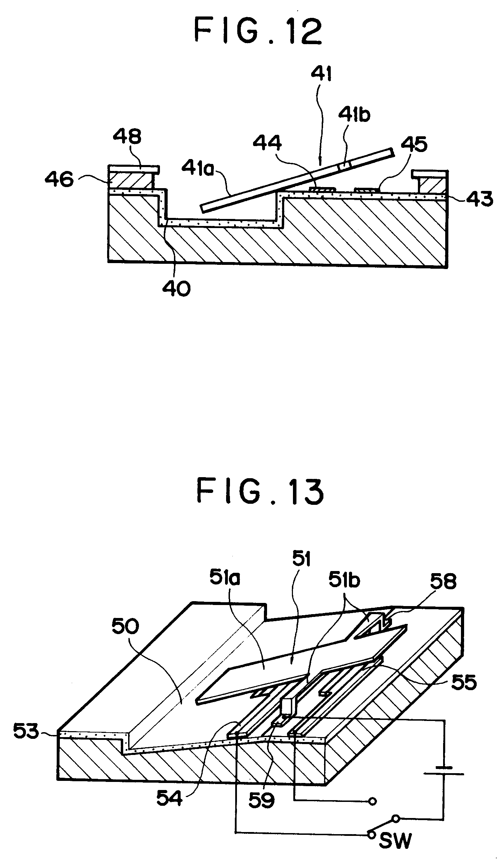

Other stationary electrode arrangements and other groove shapes of the first embodiment of the optical deflector according to the present invention will be described with reference to Figs. 10 to 12. Fig. 10 is a view showing a structure in which the stationary electrodes of the first embodiment of the present invention are formed on a part of a substrate surface where a groove is not formed. Figs. 11 and 12 are views showing structures in which the stationary electrodes of the first embodiment of the optical deflector are formed on substrate surfaces where grooves are not formed, and grooves with rectangular sections are formed.

The optical deflector shown in Fig. 10 has the same structure as that of the first embodiment except for the layout of the stationary electrodes. As compared with a case wherein the stationary electrode is formed at one side of the groove, the distance between a stationary electrode 24 and a mirror 21a consisting of an electric conductor thin film can be further shortened, thereby obtaining a lower-voltage arrangement.

Fig. 11 shows a groove 30 with a rectangular section obtained by etching a substrate. One free end of a mirror 31a is in contact with the bottom surface of the groove 30. The groove shape need not be obtained by etching having vertical directivity for vertically etching the substrate, as shown in Fig. 11. A groove formed by isotropic etching using a chemical reaction may be used if a stationary electrode 34 will not be brought into contact with the mirror 31a serving as an electric conductor.

In a groove 40 with a rectangular section shown in Fig. 12, the lower surface of a mirror 41a is in contact with an end portion of the groove 40, and the light deflection angle can be stably maintained by the spatial layout of a stationary electrode 44, the mirror 41a and beams 41b. In this case, the spatial arrangement of the stationary electrodes is less strict than those in Figs. 10 and 11.

Fig. 13 is a perspective view for explaining another arrangement of a support portion of the first embodiment of the optical deflector according to the present invention. The support portion 18 for the mirror 11a and the beams 11b in Fig. 2 is supported on the same level as that of one surface of the mirror 11a. However, a support portion 58 for supporting a mirror 51a and beams 51b through a contact portion 59 (joining portion) formed on a substrate is formed in Fig. 13. When the support portion 58 is arranged in this manner, reflection of incident light on the surface of the support portion 18 in Fig. 2 can be suppressed. In addition, the spacers 16 for fixing the support portion 18 can be omitted, and the distance between adjacent ones of a plurality of optical deflectors can be shortened, thereby arranging the optical deflectors at a higher density. In order to obtain such an arrangement, of the manufacturing steps shown in Figs. 9A to 9F, in the step of Fig. 9C, after burying and spacer formation are performed, a contact hole is formed in part of the photoresist 116 to partially expose the substrate, and the same process as in formation of an Al film is performed to obtain an optical deflector. In the arrangement of Fig. 13, the buried portion and the spacer portion can be omitted. As another effect, the omission of the spacers provides an optical deflector having a high heat resistance almost free from heat damage because an organic polymer sensitive to heat damage such as heat shrinkage and thermal solidification is absent even if the temperature of the optical deflector is increased by an external factor such as abnormal heating of a light source, as compared with the conventional spatial optical modulator (Japanese Laid-Open Patent Application 2-8812) and the embodiment of Fig. 2 in which the organic polymer film is left as spacers. A method of applying a voltage to the deflector to perform deflection is not explained in the first embodiment. As a method of applying voltages to stationary electrodes 54 and 55, a switch can be connected to a DC voltage source shown in Fig. 13 to switch a voltage applied to the stationary electrodes. This method of voltage application can be used as a common method in the present invention. The switch may be a MOS transistor formed on the substrate surface or at one side of the groove in the steps of Fig. 9B or 9C, thereby realizing an integrated arrangement.

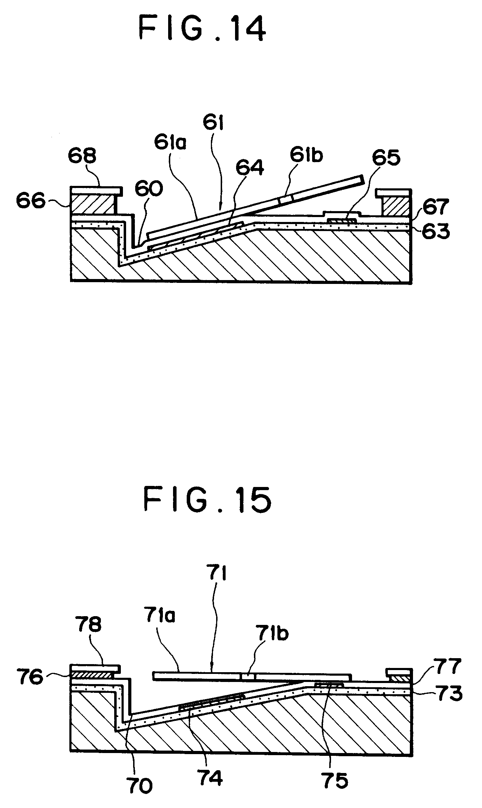

Fig. 14 is a sectional view for explaining the structure of the second embodiment of an optical deflector according to the present invention. As compared with the first embodiment of the optical deflector according to the present invention, a dielectric thin film 67 is formed on stationary electrodes 64 and 65. A mirror 61a will not be brought into contact with and electrically connected to the stationary electrodes 64 and 65 due to the presence of the dielectric thin film formed on these stationary electrodes. The limitations as to the layout between the stationary electrodes 64 and 65 and the mirror 61a become less strict. In addition, one cantilevered plate of the mirror 61a is in surface contact with the surface of the dielectric thin film 67 formed at one side of a V-groove 60. Even if the mirror 61a warps, the mirror 61a can be brought into surface contact with the dielectric thin film 67 by electrostatic attraction. For this reason, the mirror surface can directly reflect the surface precision of the dielectric thin film on the V-groove, thereby solving a problem caused by a decrease in deflection area caused by warpage of the mirror 61a. The deflection angle of the mirror 61a is fixed by the substrate surface regardless of the thickness of the spacers, thereby solving a problem such as an error of the deflection angle.

Fig. 15 is a sectional view for explaining another arrangement of the second embodiment of the present invention. Referring to Fig. 15, the other cantilevered free end of a mirror 71a is in surface contact with a dielectric thin film 77 formed on a stationary electrode 75 formed on a substrate surface. With this arrangement, as in the embodiment shown in Fig. 14, the surface precision of the substrate is reflected despite any warpage of the mirror 71a to allow angle compensation of the deflection area as in the embodiment shown in Fig. 14. The dielectric thin film 77 insulates stationary electrodes 74 and 75 from the mirror 71a as an electric conductor. At the same time, when the mirror 71a is brought into contact through the stationary electrode 75, the electrical capacitance of the dielectric thin film 77 increases in proportion to its relative dielectric constant as compared to that in a non-contact state. For this reason, the dielectric thin film 77 has an effect of increasing the electrostatic attraction force generated between the stationary electrode 75 and the mirror 71a. That is, even if the mirror 71a warps due to the internal stress of the electric conductor thin film constituting the mirror 71a at a low voltage, tight contact between the mirror 71a and the dielectric thin film 77 can be improved. Therefore, a dielectric thin film preferably has a large relative dielectric constant, i.e., ferroelectric properties.

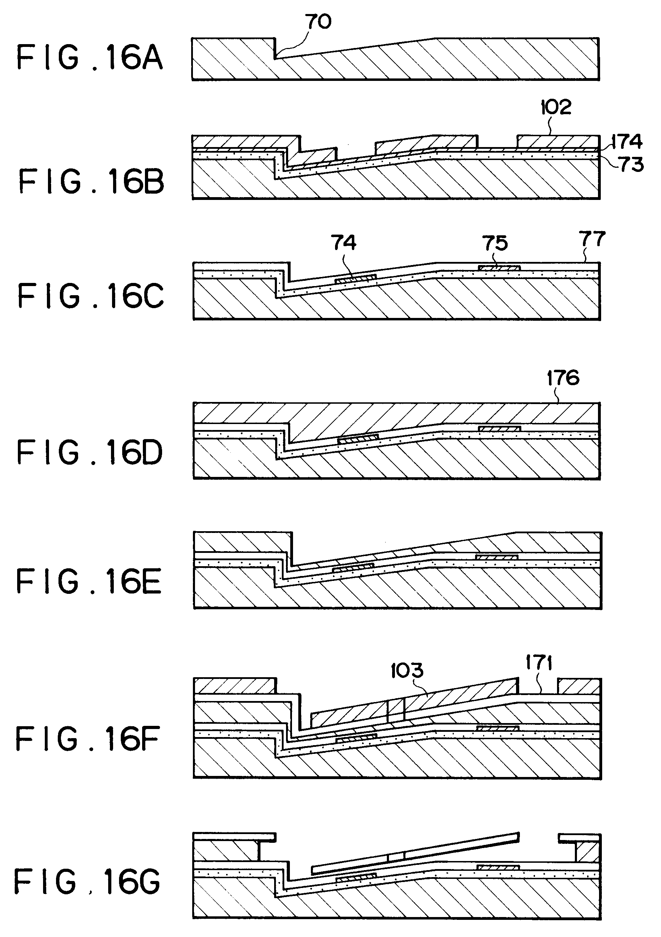

The steps in manufacturing the optical deflector shown in Fig. 15 will be described with reference to Figs. 16A to 16G. That is, Figs. 16A to 16G are sectional views showing the steps in manufacturing the second embodiment of the present invention.

As shown in Fig. 16A, a V-groove was formed in an Si substrate by the oblique ion etching method. Ar ions were radiated from an ion etching apparatus onto the Si substrate at an angle of 70°, an acceleration voltage of 1.5 kV and an ion current of 1.5 mA, using a photoresist mask patterned in a grating form, thereby forming a V-groove 70 having an angle Θ (Fig. 4) of 17° in the silicon substrate. The maximum depth of the V-groove 70 was 3 µm.

The Si substrate having the V-groove 70 was loaded in an oxidation furnace heated to 1,100°C. An oxidation gas mixture of oxygen and hydrogen was supplied to the furnace to form a 1-µm thick thermal silicon oxide film serving as an insulating layer 73, as shown in Fig. 16B. A 1,000-Å thick Al film 174 was formed by the sputtering method and was patterned by reactive ion etching (RIE) using an etching gas mixture of BCl₃ and Cl₂ and using as a mask a photoresist 102 coated, exposed and developed into a pattern (Fig. 16B), thereby forming stationary electrodes 74 and 75 shown in Fig. 16C. A dielectric thin film 77 consisting of AlN was formed on the stationary electrodes 74 and 75 by reactive sputtering using Al as a target material and a nitrogen gas as a sputtering gas.

After the groove 70 was buried and flattened, spacers 76 (Fig. 15) were formed. In this case, a photoresist 176 as shown in Fig. 16D was coated to realize a method of simultaneously burying the groove and forming the spacers 76 (Fig. 15). The photoresist 176 was formed such that a positive photoresist (AZ4620; tradename) available from Hoechst was diluted with a solvent to obtain an appropriate viscosity and the resultant solution was repeatedly coated until a flat surface was obtained. Thereafter, the photoresist 176 was etched back using CF₄ gas in accordance with reactive ion etching (RIE) until the thickness (t₁ in Fig. 4) of the spacer became 1.5 µm.

As shown in Fig. 16E, a V-groove was formed in the photoresist 176 using the method (Fig. 8) of forming a micro-structure using the halftone mask. The V-groove formed in the photoresist 176 had the same angle as that of the V-groove formed in the substrate. The halftone mask was formed by adjusting the thickness of a chromium film serving as a light-shielding portion during photolithography on the quartz substrate.

As shown in Fig. 16F, gold (Au) was deposited to form a 3,000-Å thick film using a tungsten (W) boat by a resistive heating deposition method as one of the vacuum deposition methods, thereby forming an Au thin film 171 serving as a mirror and beams subjected to torsional rotation. A photoresist 103 was coated on the surface of gold (Au) and patterned in accordance with the photolithographic process. By this patterning, Au was etched using an aqueous etching solution containing iodine and potassium iodide. Thereafter, the photoresists 103 and 176 on the Au and below the mirror and the beams were etched and removed by RIE using an oxygen plasma, thereby manufacturing the optical deflector shown in Fig. 15 (Fig. 16G). The etching conditions for the photoresist using the oxygen plasma were the same as those of the first embodiment. After the photoresist were removed, a pattern of beams 71b was formed on the dielectric thin film 77 on the stationary electrode 75 at a position where the mirror 71a was to be in surface contact. When a voltage of 10 V was applied to the stationary electrode 75 of the resultant optical deflector, the mirror 71a was brought into contact with the dielectric thin film 77, while the free end of the mirror 71a warped upward above the substrate by 1 µm. In addition, when the voltage has further increased to 30 V, the free end of the mirror was also brought into contact with the substrate, thereby achieving the surface contact. The optical deflector according to the present invention could perform angle compensation of the deflection surface of the mirror even if the mirror warped.

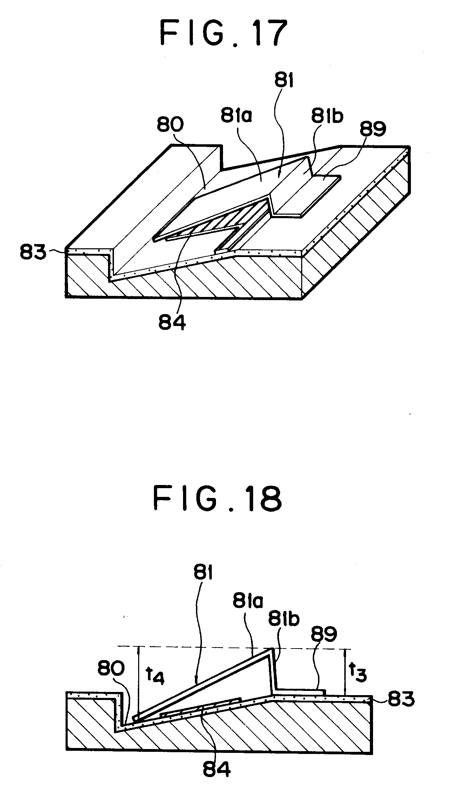

Fig. 17 is a perspective view for explaining the structure of the third embodiment of an optical deflector according to the present invention, and Fig. 18 is a sectional view thereof.

A stationary electrode 84 is formed on a substrate having a groove 80 through an insulating layer 83, and a mirror 81a is cantilevered by a support portion 81b through a contact portion 89 on the insulating layer 83. The mirror 81a and the support portion 81b constitute a mechanically movable portion 81. When a voltage is applied to the stationary electrode 84, the mirror surface is displaced toward the stationary electrode 84 by electrostatic attraction. At this time, an L-shaped portion between the mirror 81a and the support portion 81b, which serves as the proximal portion of the mirror 81a, and an L-shaped portion between the support portion 81b and the contact portion 89 are deformed, and the mirror surface will not deform. As shown in Fig. 18, a mirror stop position obtained when a voltage is not applied to the stationary electrode 84 is represented by a distance t₃ from the substrate surface, and a distance from the mirror stop position which is determined when the free end of the mirror 81a is brought into contact with one side of the groove 80 is defined as t₄. If no groove is present, the maximum deflection angle of the optical deflector is determined by the distance t₃ and the longitudinal dimension of the mirror 81a. The deflection angle can be further increased when the groove 80 shown in this embodiment is formed. The distance between the stationary electrode 84 and the mirror 81a is shortened for the same deflection angle, thereby obtaining a low-voltage arrangement. In addition, spacers are omitted from the optical deflector of this embodiment, so that the optical deflector has an arrangement suitable for an array for the same reason as that of the optical deflector described with reference to the first embodiment shown in Fig. 13. Referring to Fig. 18, the contact portion 89 is formed on the insulating layer 83. However, when the contact portion 89 is electrically grounded to the substrate, a window for the contact portion 89 may be formed in the insulating layer 83 so as to electrically connect the contact portion 89 to the substrate.

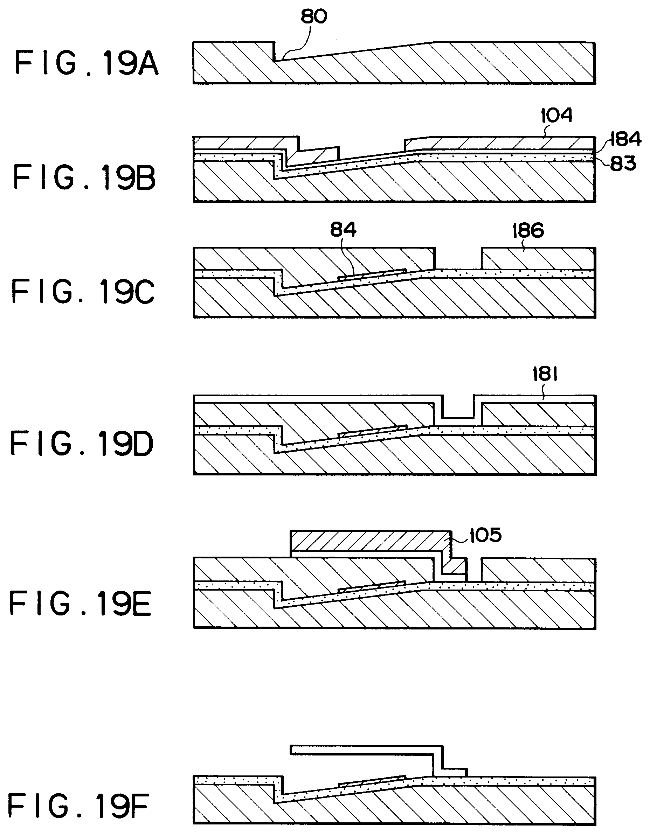

Steps in manufacturing the third embodiment of the optical deflector described above will be described with reference to Figs. 19A to 19F. That is, Figs. 19A to 19F are sectional views for explaining the steps in manufacturing the third embodiment of the optical deflector according to the present invention.

As shown in Fig. 19A, a V-groove was formed in an Si substrate by anisotropic etching. At this time, the silicon substrate had an angle Θ (Fig. 7) of 19.4°. The (111) plane of one side of the V-groove was perpendicular to the surface of the substrate, and the maximum groove depth was 3.5 µm.

A 3,000-Å thick silicon nitride film was formed on the Si substrate having the V-groove by low-pressure CVD (LPCVD) to form an insulating film 83. A 1,500-Å thick polysilicon film 184 serving as stationary electrodes was formed by LPCVD at 620°C. Phosphorus (P) was ion-implanted at a dose of 1 x 16¹⁶ (ions/cm²) in accordance with the ion-implantation method and was diffused in a nitrogen atmosphere at 1,100°C for an hour. As a result, the sheet resistance of polysilicon was 12 Ω/□. A photoresist 104 was coated on the polysilicon film 184 and patterned into a photoresist 103 by the photolithographic process for performing exposure and development (Fig. 19B), and the polysilicon film 184 was patterned by reactive ion etching (RIE) using CF₄ as an etching gas. The resist pattern was then removed to form a stationary electrode 84 shown in Fig. 19C. As shown in Fig. 19C, a silicon oxide film 186 to be finally removed to form a space was formed on the stationary electrode by the bias sputtering method (Gekkan Semiconductor World, Press Journal, 1984, 10, pp. 121-128), as shown in Fig. 19C. More specifically, a bias voltage of -200 V was applied to the substrate to form a 1.5-µm thick silicon oxide film 186 for burying the groove and flattening the resultant surface, and the silicon oxide film 186 was etched back using a CF₄ gas such that the distance t₃ shown in Fig. 18 became 1.5 µm. In order to improve flatness of the etched-back silicon oxide film, a resist was formed on the silicon oxide film and the oxide film was etched back. Part of the silicon oxide film 186 was removed by photolithography to form the contact portion 89, as shown in Fig. 19C. The silicon oxide film was removed by reactive ion etching using a gas mixture of CHF₃ and CF₄ and a resist mask such that the side surface of the etched film was vertical.

A 3,000-Å thick polysilicon film 181 as an electric conductor thin film constituting the mirror, the support portion and the contact portion was formed on the silicon oxide film 186 at 600°C by LPCVD, as shown in Fig. 19D, and phosphorus (P) was ion-implanted at a dose of 1 x 10¹⁶ (ions/cm²) in accordance with the ion-implantation method and diffused in a nitrogen atmosphere at 1,100°C for three hours. As a result, the stress of the polysilicon film was a compressive stress which was 1.2 x 10⁸ dyn/cm². The polysilicon on the step of the silicon oxide film in the contact portion 89 became thin to be susceptible to deformation.

As shown in Fig. 19E, a photoresist 105 was formed on the electric conductor thin film 181 serving as the mirror, the support portion, and the contact portion and patterned by photolithography. The same etching method as in polysilicon of the stationary electrode 84 was performed.

Finally, the silicon oxide film formed by the bias sputtering method was etched and removed by an aqueous hydrofluoric acid solution, thereby manufacturing an optical deflector of the embodiment shown in Fig. 19F.

The optical deflector shown in Figs. 17 and 18 was formed by the above manufacturing steps. When the support portion 81b is arranged as described above, reflection of incident light on the support portion can be suppressed as in the optical deflector shown in Fig. 13. By omitting the spacers, the distance between adjacent ones of an array of optical deflectors of this embodiment can be shorted, and the optical deflectors can be arranged at a higher density. This optical deflector has a high heat resistance which is almost free from heat damage. In addition, using a cantilevered mirror, even if the optical deflector is heated, mechanical deformation caused by the heat stress acting on the mirror caused by a difference between the thermal expansion coefficients of the substrate and the mirror can be prevented. In addition, since the groove is formed in the substrate as in the first and second embodiments, the deflection angle can be set large, and at the same time a low-voltage arrangement can be obtained.

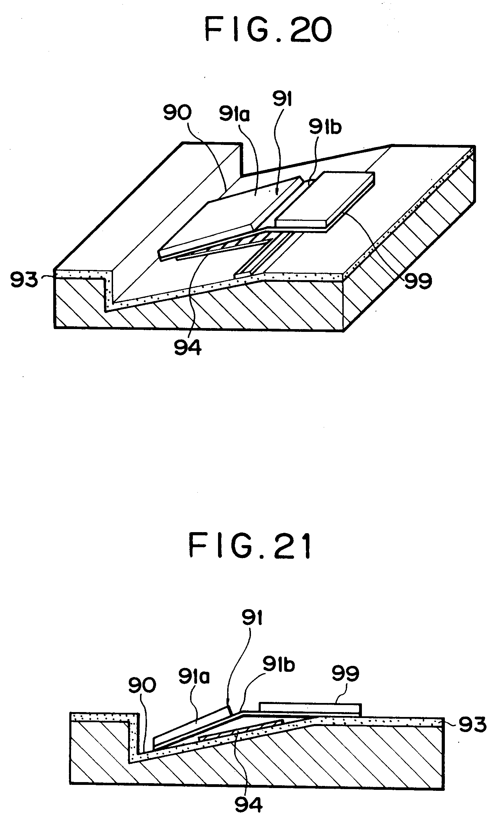

Fig. 20 is a perspective view for explaining the structure of the fourth embodiment of an optical deflector according to the present invention, and Fig. 21 is a sectional view thereof.

A stationary electrode 94 is formed on a substrate having a groove 90 through an insulating layer 93, and a flexible plate 91b is cantilevered on the substrate having the insulating layer 93 through a contact portion 99. A mirror 91a is formed on the flexible plate 91b. When a voltage is applied to the stationary electrode 94, the mirror surface is displaced toward the stationary electrode 94 by electrostatic attraction. At this time, although the flexible plate 91b flexes, the mirror surface does not deform. The mirror surface has the same level as that of the substrate when a voltage is not applied to the stationary electrode 94. The support portion, the spacers, and the like described with reference to the first to third embodiments are not arranged in the optical deflector of this embodiment. The deflection angle is determined by the depth of the groove. In the manufacturing steps, the spacers need not be formed, but only the groove need be buried. The distance between the stationary electrode and the mirror can be set short for the same deflection angle, and a low-voltage arrangement can be realized. The optical deflector of this embodiment does not require spacers and can suitably formed into an array. At the same time, the optical deflector apparently has thermal stability as may be apparent from the description of the first embodiment and the same reason as in the third embodiment having a cantilevered structure. Referring to Fig. 21, the contact portion 99 is formed on the insulating layer 93. However, when the substrate is to be electrically grounded, a window for the contact portion 99 may be formed in the insulating layer 93 to electrically connect the contact portion 99 to the substrate. A transistor can be formed at one side of the groove to obtain an integrated arrangement.

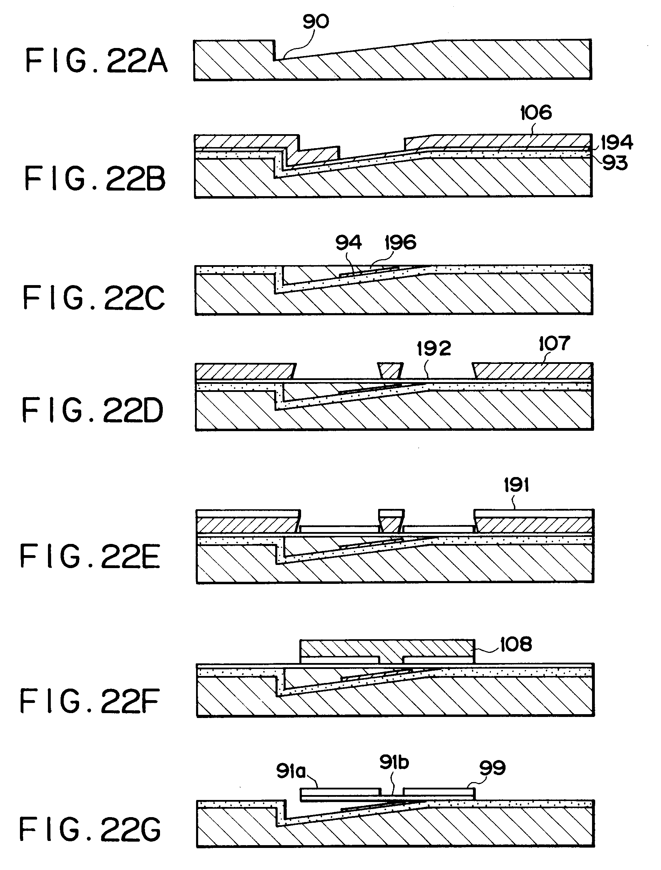

The steps in manufacturing the optical deflector described above will be described with reference to Figs. 22A to 22G. That is, Figs. 22A to 22G are sectional views for explaining the steps in manufacturing the fourth embodiment of the optical deflector according to the present invention.

As shown in Fig. 22A, a V-groove 90 was formed in an Si substrate by anisotropic etching. This substrate is prepared as in the substrate of the first embodiment.

As shown in Fig. 22B, a 1-µm thick thermal silicon oxide film was formed as an insulating layer 93 on the Si substrate, and a 1000-Å thick Al film 194 was formed by the sputtering method using a photoresist 106 coated, exposed, developed, and patterned as a mask.

As shown in Fig. 22C, the Al film 194 was patterned by RIE using an etching gas mixture of BCl₃ and Cl₂ to form a stationary electrode 94. A burying resist 196 as a burying resin was coated on the groove 90 and etched back until the resin surface became the same level as that of the substrate surface. In this manner, no spacers were formed in the optical deflector of this embodiment.

An Al film 192 serving as a flexible plate 91b having electrical conductivity was sputtered by the sputtering method using argon to form an Al film having a thickness of 1,000 Å. As shown in Fig. 22D, a photoresist 107 (negative resist; tradename RD2000N) available from Hitachi Chemical Co., Ltd. was coated, exposed, and patterned on the Al film 192. In this case, the resist film was developed such that its sectional shape was an inverted tapered shape.

As shown in Fig. 22E, a 3,000-Å thick film 191 was formed by the vacuum electron beam deposition method.

As shown in Fig. 22F, the photoresist 107 was removed by an etching solution to lift off the Al film 191 on the photoresist 107, thereby forming a mirror 91a and a contact portion 99. In lift-off, the groove burying resist 196 used to bury the groove 90 must not be removed with an etching solution. The resist 196 can consist of, e.g., polyimide or polyamide. The flexible plate and the contact portion are covered with a photoresist 108, and the Al film 192 is patterned by RIE using an etching gas mixture of BCl₃ and Cl₂.

The photoresist 108 on the Al film 194 and the groove burying resist 196 under the mirror 91a were etched and removed by RIE using an oxygen plasma, thereby manufacturing the optical deflector shown in Fig. 22G.

The optical deflector according to the embodiment shown in Figs. 20 and 21 was manufactured by the above manufacturing steps. As described above, the groove is formed in the substrate, and the flexible plate 91b having a thickness smaller than the thickness of the mirror 91a is arranged to obtain a compact optical deflector requiring a small space. Since spacers are not used in this embodiment, the distance between adjacent ones of an array of optical deflectors of this embodiment can be shortened, and the optical deflectors can be arranged at a higher density. The optical deflector has a high heat resistance and is almost free from heat damage. As in the first and second embodiments, since the groove is formed in the substrate, the deflection angle can be set large, and a low-voltage arrangement can be obtained. When a photoresist is used to form spacers, this photoresist diluted with an organic solvent to have an appropriate viscosity is coated on the substrate. For this reason, the viscosity of the diluted photoresist may change during the application to cause changes in spacer thicknesses, thereby causing a deflection angle error. For this reason, sufficient process control must be performed. However, in the optical deflector of this embodiment, spacers need not be formed, and an excellent optical deflector at a high yield can be obtained.

The structure, manufacturing steps, and operation of the optical deflector of the present invention have been described above with reference to the preferred embodiments. In the first to fourth embodiments, stationary electrodes are formed on a substrate through an insulating layer. However, the insulating layer need not be formed if the substrate consists of glass or the like having electrical insulating properties. If a semiconductor material such as silicon (Si) is used for the substrate, diffusion layers doped with an impurity by ion implantation or the like can be used as the stationary electrodes. In the manufacturing method of the third embodiment, the silicon oxide films are used as the groove burying and spacer materials. However, as in the first and fourth embodiments, a photoresist or resist may be used to perform etching using an oxygen plasma. In a structure having a contact portion shown in each of Figs. 13, 17, and 20, when a photoresist or resist is used as a groove burying material, a solvent for dissolving the photoresist or resist may be used. In all the embodiments described above, the photoresist and the silicon oxide film are used as the groove burying material or the groove burying and spacer materials. However, these materials are not limited to specific ones. For example, a Ti thin film or a Ti/W metal alloy thin film may be formed by the vacuum deposition method such as the resistive heating deposition method or the electron beam deposition method, and the space forming material may be etched using a hydrogen peroxide solution in Figs. 11 and 14, thereby forming the same optical deflector as in the above embodiments. In this case, the stationary electrodes and the mechanically movable portion consist of a material which can withstand etching. The groove burying material need not be the same as the spacer material. After the groove is buried in accordance with the method described with reference to the fourth embodiment, spacers may be then formed by another material. An Al, Au, or ion-implanted polysilicon film having a low resistance is used as the electric conductor thin film. However, a metal, a semi-metal, and a semiconductor having a low resistance and electrical conductivity, all of which are exemplified by Al, Ag, Cu, Ga, Ge, In, and Si can be used if a mirror, stationary electrodes, a dielectric thin film, and the like which constitute the elements of an optical deflector are not etched in removal of the groove burying material and the spacer material. As a thin film material used for a mirror, a material having a high reflectance may be selected depending on the wavelength of light to be deflected. Examples of the material for the mirror are a metal material (e.g., Ag, Al, Ni, Pt, Au, Cu, Ti, Co, or Zn) having a high reflectance in the range from the infrared region to the ultraviolet region. Such a metal material is not limited to an element itself, but can be an alloyed material consisting of two or more types of metal elements. In the second embodiment, the dielectric thin film is used. The dielectric thin film is limited not to the AlN film, but can be replaced with any other electrical insulating material such as SiO, Si₃N₄, ZrO₂, TiO₂, MgO, Al₂O₃, SiC, SiON, ZnO, or Ta₂O₅. In the second embodiment, to reduce the voltage applied to the stationary electrode, a dielectric material having a large dielectric constant can be used. An insulating dielectric thin film material having a large dielectric constant can be used to reduce the voltage required for performing surface contact between the mirror and the dielectric thin film. As a ferroelectric material, a material such as TiBaO, PbZrTiO, or PbTiO which can be formed by thin film techniques can be used. An organic polymer thin film may be used as the dielectric thin film. In forming a space, a space forming material which can prevent etching of the organic polymer thin film used as the dielectric thin film can be used. A combination of coating and etch back of a photoresist or resist (resin) and a flattening technique using the bias sputtering method are used to bury the groove. Another method may be a method of burying the groove and flattening the resultant surface by the chemical vapor deposition method (CVD method) or plasma CVD using an organic silicon (e.g., TEOS or tetraethylorthosilicate Si(OC₂H₅)₄) as a source material (Gekkan Semiconductor World, 1992, 1, pp. 140-173).

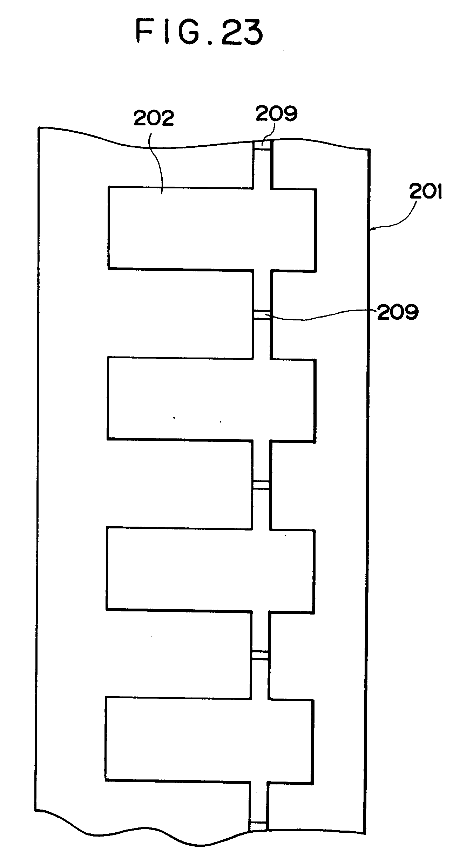

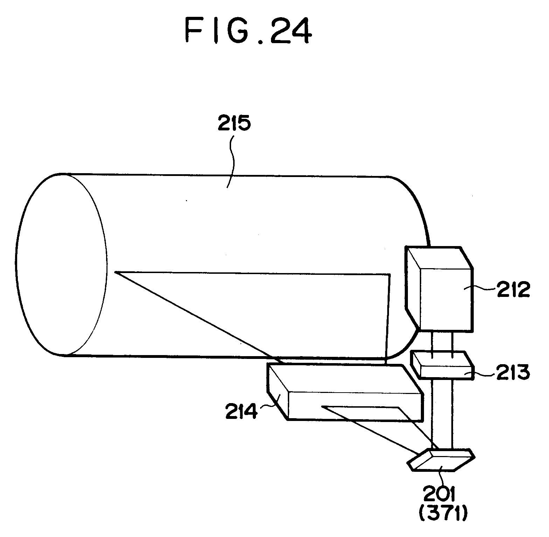

An image display device as an application using the optical deflector according to the present invention will be described below. Fig. 23 is a view showing an image display device in which optical deflectors each constituting the first embodiment shown in Fig. 13 are arrayed on a single substrate to constitute a micro-mirror array. Fig. 24 is a view showing an application to electrostatic printing of the image display device shown in Fig. 23.

Independent stationary electrodes (not shown) are arranged below each mirror 202, and the individual optical deflectors can independently control deflection states and deflection light amounts. A contact portion 209 common to the adjacent mirrors 202 is formed on the substrate. The application to electrostatic printing of an image display device 201 is shown in Fig. 24. Light from a light source 212 is radiated on the image display device 201 through a lens 213. The individual optical deflectors of the image display device 201 independently apply voltages to the corresponding stationary electrodes to control the corresponding mirrors. Incident light beams are deflected toward a lens 214 through the corresponding mirrors to focus deflected light on a photosensitive drum 215. Electrostatic printing is performed in accordance with a conventional method to form an image. In the image display device according to the present invention, the mirror deflection angle can be set large, and only a low voltage is required. For this reason, a compact image display device which requires a low power for driving each mirror can be obtained.

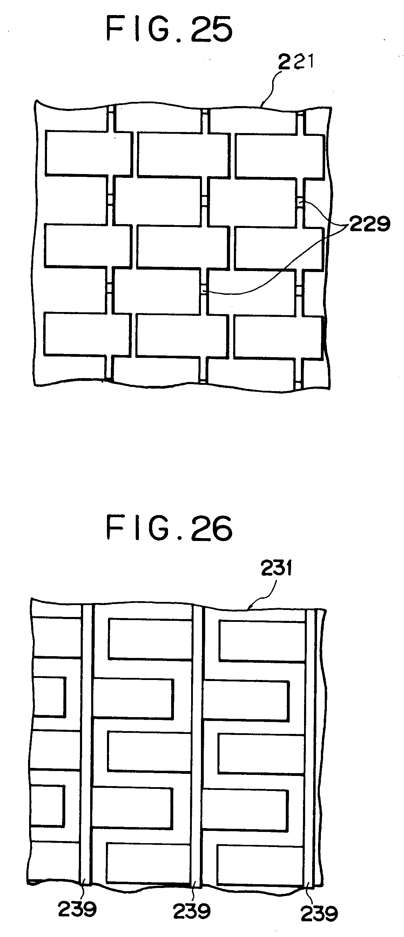

Fig. 25 is a plan view showing a structure in which the image display devices each shown in Fig. 23 are two-dimensionally arrayed, and Fig. 26 is a plan view showing an image display device in which the optical deflectors each shown in Fig. 17 or 20 are two-dimensionally arrayed. Image display devices 221 and image display devices 231 shown in Figs. 25 and 26 are used to arrange a projection display. In these image display devices, one optical deflector forms one pixel. A contact portion 229 for each optical deflector in Fig. 25 and a common contact portion 239 for a plurality of optical deflectors in Fig. 26 are arranged.

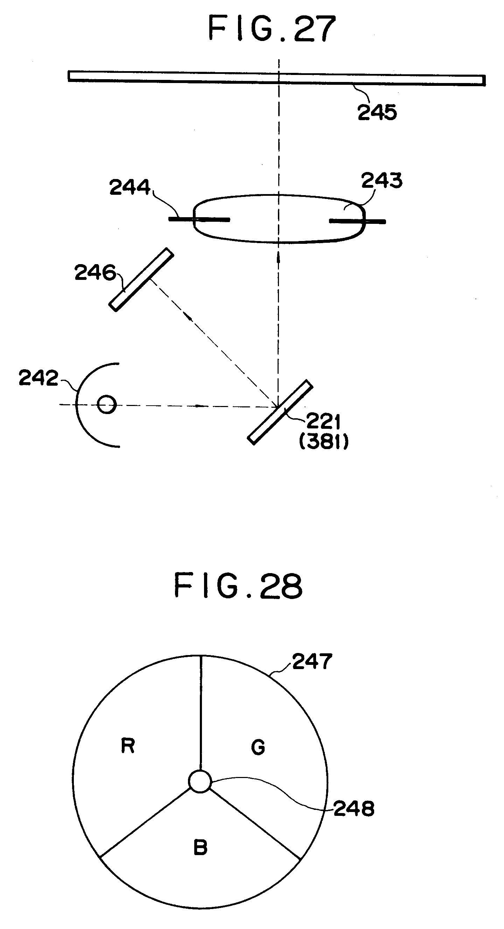

Fig. 27 is a view showing an optical system obtained when the image display device shown in Fig. 25 is applied to a projection display. Of light from an illumination system 242, desired image data is reflected by each mirror in the image display device 221 and projected on a screen 245 through a projection lens 243 and a stop 244. When an image is not to be displayed, light is reflected toward a light-shielding plate 246 by adjusting the mirror angles (i.e., a reflecting direction 4 in Fig. 5). A projection display having one pixel corresponding to one mirror can be arranged using the image display device having the optical deflectors of the present invention. In order to display the image data formed by this image display device in the form of a color image, three optical systems and three image display devices, each shown in Fig. 27, are arranged, and red (R), green (G), and blue (B) color filters consisting of different color agents are arranged in front of or behind the respective image display devices 221 (Fig. 25). Images from the respective image display devices are projected on a single screen, thereby displaying a full-color image.

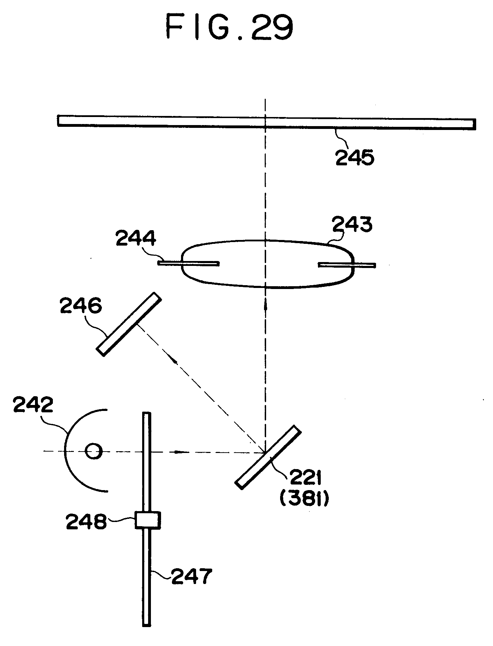

Fig. 28 is a view showing the structure of a color filter for arranging the image display device in Fig. 27 as a color image display device. Fig. 29 is a view showing an optical system using the color filter shown in Fig. 28. As another optical system for color display, a color filter 247 consisting of a tricolor (RGB) filter (Fig. 28) is arranged in front of or behind the image display device along the optical path and is rotated about a rotating shaft 248 to obtain a color image, as shown in Fig. 29. In this case, the image display device forms an image synchronously and independently with respect to the color components. In the optical system shown in Fig. 27, the three image display devices are required. However, a color projection display can be manufactured using one image display device.

According to the optical deflector according to the present invention, as has been described above, a groove is formed on a substrate to receive at least one free end of an optical deflecting plate arranged in a mechanically movable portion. For this reason, even if a long spatial distance between the substrate and the mechanically movable portion is not set, a large deflection angle can be obtained, and at the same time an optical deflecting plate can be driven at a low voltage.

An optical deflector which does not need spacers for forming a space can be obtained upon forming the groove in the substrate, thereby obtaining a structure which can facilitate management of the manufacturing process.

A dielectric thin film is formed on a stationary electrode, and one surface of the optical deflecting plate is brought into surface contact with the dielectric thin film formed on the stationary electrode. Therefore, a deflection angle error caused by warpage of the surface of the optical deflecting plate due to a film stress can be eliminated.

A compact, low-cost image display device can be provided by arraying optical deflectors of the present invention.

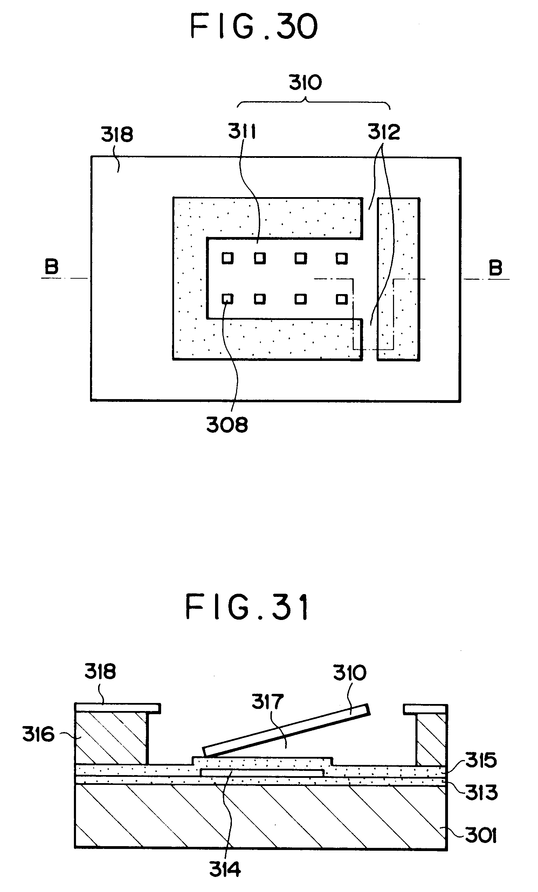

Still another embodiment of the present invention will be described with reference to the accompanying drawings. Fig. 30 is a plan view showing the fifth embodiment of an optical deflector according to the present invention, and Fig. 31 is a sectional view of the optical deflector along the line B - B in Fig. 30. Fig. 31 apparently shows a state in which a voltage (electrostatic voltage) for bringing the free end of a mirror portion 311 into slight contact with a dielectric thin film is applied between the mirror portion 311 and a stationary electrode 314. When a voltage is not applied between the mirror portion 311 and the stationary electrode 314, the mirror portion 311 is kept parallel to the stationary electrode 314.

An insulating layer 313 is formed on a substrate 301, and the stationary electrode 314 made of a rectangular metal layer having a predetermined size is formed on the insulating layer 313. In addition, a dielectric thin film layer 315 is formed on the insulating layer 313 and the stationary electrode 314.

Spacers 316 are formed on the dielectric thin film layer 315, and a support portion 318 made of a metal layer is formed on the upper surface of the spacers 316. The mirror portion 311 is formed integral with the support portion 318 through beams 312 having a small width. The mirror portion 311 and the beams 312 serve as a mechanically movable portion 310. Holes 308 are formed in the mirror portion 311 to facilitate formation of a space 317.

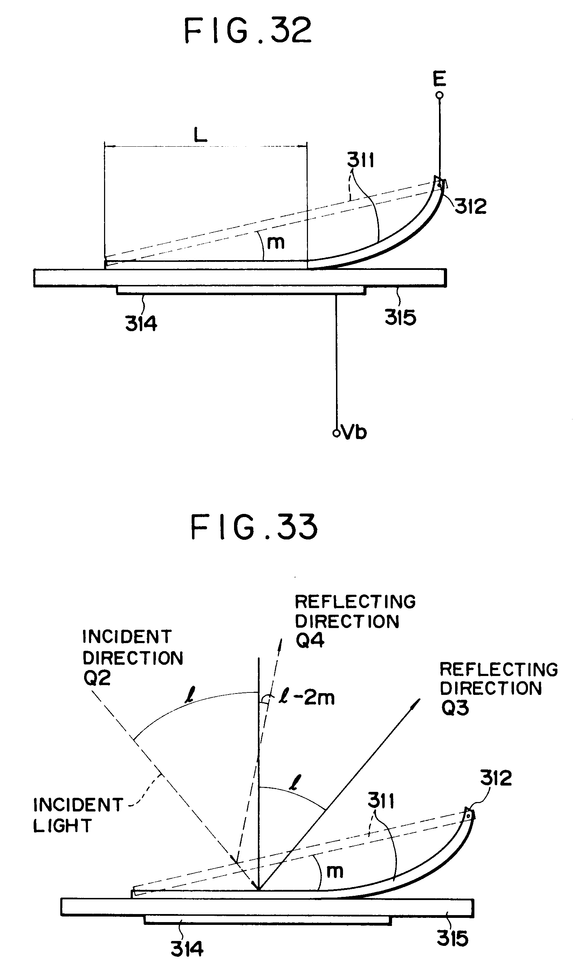

An operation of this embodiment will be described with reference to Figs. 32 and 33. When a voltage V_{b} corresponding to a bias voltage is applied to the stationary electrode 314, the beams are distorted to bring the free end of the mirror portion 311 into contact with the dielectric thin film layer 315. At this time, the angle formed between the mirror portion 311 and the dielectric thin film layer 315 is defined as m. The mechanically movable portion 310 is electrically insulated from the stationary electrode 314, and they are grounded, as shown in Fig. 32. The voltage V_{b} is applied to the mechanically movable portion to ground the stationary electrode 314. When the voltage V_{b} is further increased, the contact area between the mirror portion 311 and the dielectric thin film layer 315 increases. The contact area is represented by a contact distance (L) from the free end of the mirror portion 311 in Fig. 32. Referring to Fig. 33, incident light from an incident direction Q₂ at an angle ℓ with respect to the substrate is reflected by the mirror set in a state wherein the free end of the mirror portion 311 is in contact with the dielectric thin film layer 315. This incident light is deflected in a reflecting direction Q₄ (indicated by a dotted line in Fig. 33). When the voltage V_{b} is further increased, the light is deflected in a reflecting direction Q₃. The deflection light amount in the reflecting direction Q₃ increases with an increase in contact area of the mirror portion 311. That is, an electrostatic attraction force is generated between the mechanically movable portion 310 and the stationary electrode 314 by the voltage V_{b} to distort the beams 312, thereby deforming the mirror portion 311. The mirror portion 311 is gradually brought into contact with the dielectric thin film layer 315 from the free end. That is, the mirror surface for performing deflection directly reflects the surface precision of the substrate. Even if the mirror portion 311 warps, the mirror portion 311 can have the same surface precision as that of the dielectric thin film layer 315 on the substrate. In addition, the deflection angle of the mirror portion 311 is determined by the surface state of the substrate regardless of the thickness of the spacer, thereby preventing a problem of deflection angle errors. In addition, the contact area between the mirror portion and the dielectric thin film layer can be changed in accordance with the magnitude of the electrostatic attraction. The deflection light amount toward the reflecting direction Q₃ can thus be adjusted. The resultant optical deflector can be a compact, lightweight optical deflector array.

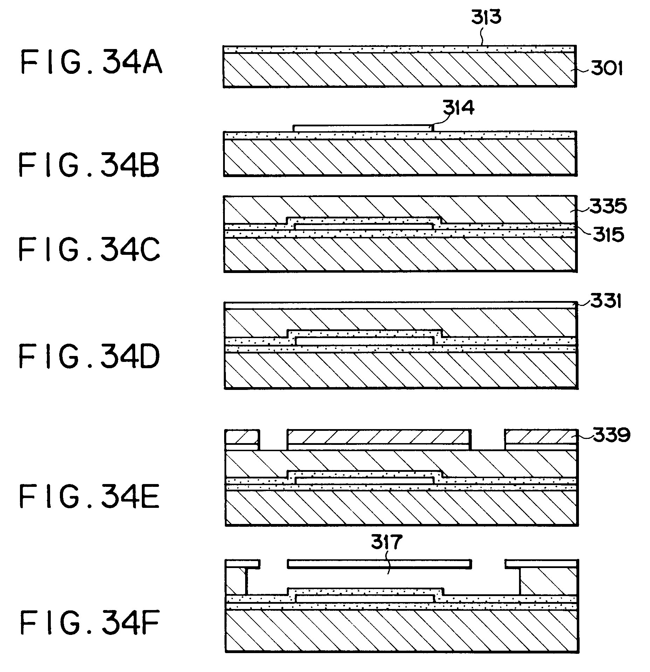

The steps in manufacturing the fifth embodiment of the optical deflector according to the present invention will be described with reference to Figs. 34A to 34F. A 3,000-Å thick silicon nitride film was formed on an Si substrate 301 by low-pressure CVD (LPCVD) (Fig. 34A). A 3,000-Å thick polysilicon film serving as a stationary electrode 314 was formed by LPCVD, and phosphorus (P) was ion-implanted at a dose of 1 x 10¹⁶ (ions/cm²) by the ion-implantation method and diffused in a nitrogen atmosphere at 1,100°C for an hour. As a result, the sheet resistance of the polysilicon film was 12 Ω/□. A photoresist was coated on the polysilicon film and patterned using a photolithographic process for performing exposure and development. A polysilicon pattern was formed using an aqueous solution mixture of hydrofluoric acid and nitric acid, and the resist pattern was removed to form the stationary electrode 314 (Fig. 34B).

A 1-µm thick silicon oxide film was formed on the resultant stationary electrode 314 by the sputtering method as one of the vacuum deposition methods, thereby forming a dielectric thin film layer 315. A 3-µm thick photoresist 335 was coated on the resultant structure by a spin coater to form a spacer layer (Fig. 34C). The photoresist 335 was a positive photoresist (AZ1350J; tradename) available from Hoechst. Using the sputtering method as one of the vacuum deposition methods, an aluminum target was sputtered using argon to deposit a 3,000-Å thick aluminum thin film 331 on the photoresist (Fig. 34D). The substrate holder was set at 5°C in sputtering to suppress the heat stress in film formation. A photoresist 339 was coated on the resultant structure and patterned in accordance with the photolithographic process to pattern Al while an etchant consisting of an aqueous solution mixture of phosphoric acid, nitric acid, acetic acid, and water was heated to 50°C, thereby forming the beams and the mirror portion (Fig. 34E). The photoresists above the Al and below the mirror portion were etched and removed to form a space 317 by reactive ion etching (RIE). At this time, the etching conditions were set such oxygen was supplied at 100 ccm or more and the gas pressure was 20 Pa or more. These etching conditions were set for increasing the side-etching amount. Although holes 308 shown in Fig. 30 were formed in the mirror portion to shorten to the etching time of the photoresist, the same structure as described can be obtained by prolonging the etching time. By the above manufacturing processes, an optical deflector shown in Fig. 34F could be obtained. In the resultant optical deflector, each beam had a width of 3.5 µm and a length of 10 µm, and the mirror portion had a length of 42 µm and a width of 30 µm, as shown in Fig. 30.

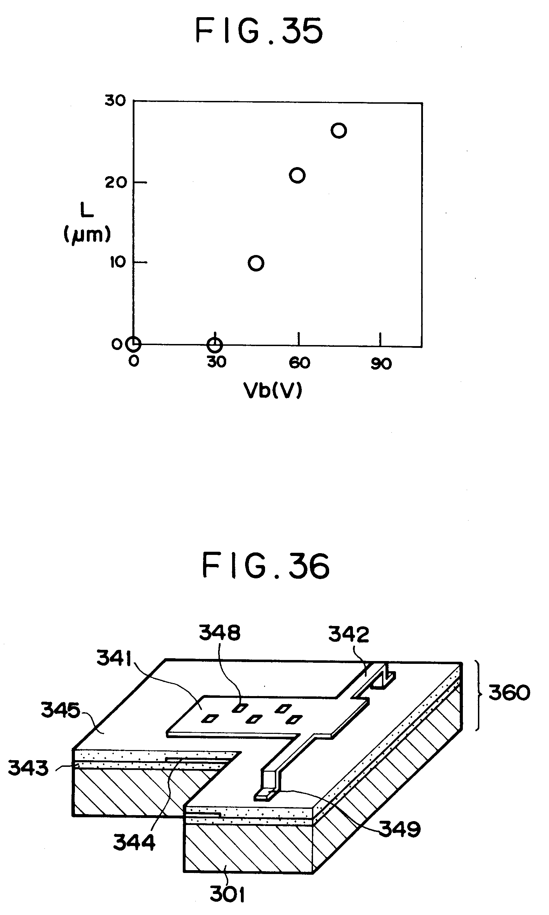

The relationship between the voltage V_{b} applied to the stationary electrode and the contact distance L of the mirror portion in contact with the silicon oxide film when the mirror portion is grounded, as shown in Fig. 32, is shown in Fig. 35. When a voltage is not applied to the stationary electrode, the mirror portion 311 is not brought into contact with the dielectric thin film layer 315. When a voltage of 30 V is applied to the stationary electrode, the free end of the mirror portion 311 is brought into contact with the dielectric thin film layer 315. When the voltage is further increased, the contact distance increases. That is, the deflection light amount of the light in the reflecting direction Q₃ in Fig. 33 increases. The voltage V_{b} at which the free end of the mirror portion is brought into contact with the dielectric thin film layer 315 is defined as a bias voltage (30 V), and a drive voltage for adjusting the deflection light amount is superposed on this bias voltage to perform light amount adjustment.

In the fifth embodiment, the silicon oxide film is used as the dielectric thin film layer. However, any material having electrical insulating properties, such as Si₃N₄, ZrO₂, (Ta₂O₅), TiO₂, MgO, Al₂O₃, SiC, SiON, AlN, or ZnO may be used as the material for the dielectric thin film layer. To reduce the drive voltage for adjusting the deflection light amount, a material having a large dielectric constant is used. That is, since the electrostatic attraction force generated when the mirror portion is brought into contact with the dielectric thin film layer is proportional to the dielectric constant, use of an insulating thin film layer material having a large dielectric constant can reduce the drive voltage for adjusting the deflection light amount. A ferroelectric material may be any material capable of forming a thin film, such as TiBaO, PbZrTiO, or PbTiO. For example, a silicon oxide film for preventing etching of an organic polymer thin film in forming the organic polymer thin film is formed on the stationary electrode to form the space 317 under the mirror portion 311 and the beams 312, and the organic polymer film can be used as the dielectric thin film layer. The organic polymer thin film can consist of polyimide, polyamide, or PMMA having insulating properties. A ferroelectric polymer material such as PVDF or P(VDF-TrFE) can be used to reduce the drive voltage. In the fifth embodiment, Al is used to form the electric conductor thin film. However, any material capable of reflecting light can be used, and its examples are a metal (e.g., Au, Cu, Ni, Ag, or Ti), a metal alloy, or a low-resistance semiconductor (e.g., Si or Ge) having electrical conductivity. A material having a high reflectance is selected as a mirror material depending on the wavelength of light to be deflected. A material for the spacer may be any material if it does not corrode the dielectric thin film layer in etching a portion below the mirror portion. This material is not limited to a resist.

The sixth embodiment of an optical deflector according to the present invention will be described with reference to Fig. 36. In this embodiment, an insulating layer 343, a stationary electrode 344, a dielectric thin film layer 345, and a mirror portion 341 on a substrate 301 are the same as those described with reference to the fifth embodiment in Figs. 30 and 31. However, extended ends of beams 342 are bent at a right angle and the terminal ends of the beams 342 are fixed as contact portions 349 on the dielectric thin film layer 345 in place of the spacers 316 and the support portion 318 which supports one side of the mirror portion 341 at a predetermined level. The contact portions 349 are formed on the dielectric thin film layer 345 such that the stationary electrode 344 is kept electrically insulated from a mechanically movable portion through the dielectric thin film layer. The dielectric thin film layer may be formed on only the stationary electrode which is brought into contact with the mechanically movable portion, and the contact portions 349 may be formed on the insulating layer 343. Alternatively, when the substrate is to be electrically grounded, a contact window may be formed in the insulating layer to electrically connect the contact portions to the substrate.

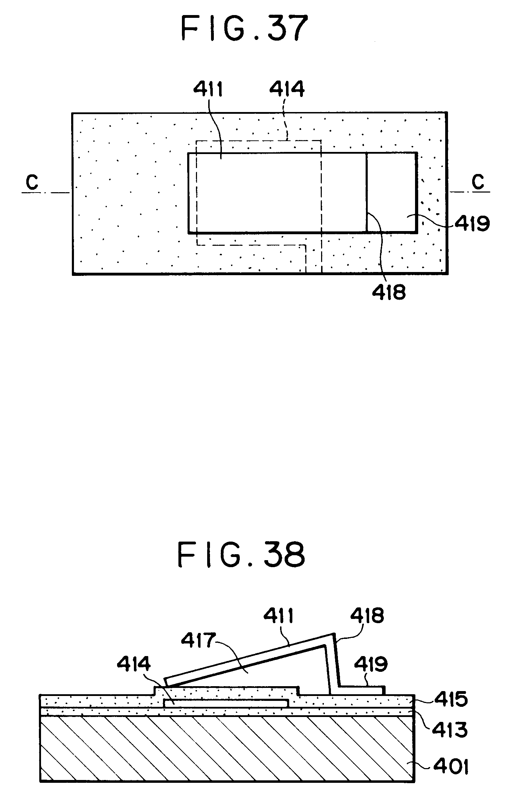

The seventh embodiment of an optical deflector according to the present invention will be described with reference to Figs. 37 and 38. In this embodiment, unlike the beams in Fig. 36, one side of the mirror portion is bent at a right angle, and its terminal end serves as a contact portion 419. The contact portion 419 is fixed on the substrate. That is, the mirror portion is cantilevered, and the mirror portion is supported at a predetermined level by a support portion 418.

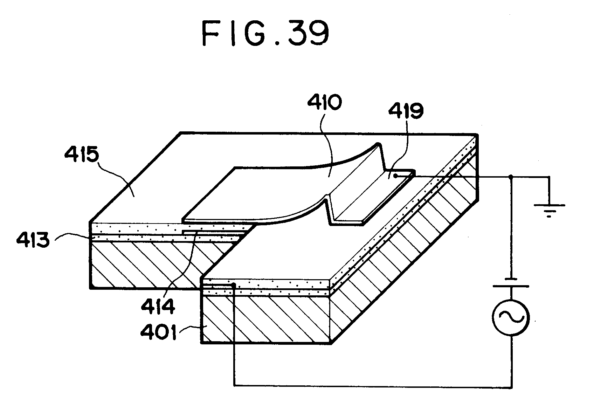

To operate the optical deflector of this embodiment, as shown in Fig. 39, a bias voltage is applied from a DC power supply and superposed on a drive voltage for bringing a mechanically movable portion into contact with a dielectric thin film by a desired area. As shown in Fig. 38, the contact portion 419 is formed on a dielectric thin film 415. However, a stationary electrode 414 need only be electrically insulated from a mechanically movable portion through the dielectric thin film. Therefor, the dielectric thin film may be formed on only the stationary electrode which is brought into contact with the mechanically movable portion, and the contact portion 419 may be formed on the insulating layer 413. Alternatively, when the substrate is to be electrically grounded, a contact window may be formed in the insulating layer to electrically connect the contact portion to the substrate. As shown in Fig. 38, the stationary electrode is formed on the substrate through the insulating layer. However, the insulating layer may be omitted if the substrate is made of a material (e.g., glass) having insulating properties. If a semiconductor material such as Si is used as a substrate, a diffusion layer doped with an impurity by ion implantation can be used as the stationary electrode. In Fig. 39, the bias and drive voltages are applied to the stationary electrode, and the mechanically movable portion is grounded. However, a voltage may be applied to the mechanically movable portion. The operation of this embodiment is the same as that of the embodiment in Fig. 30 and can be readily understood.

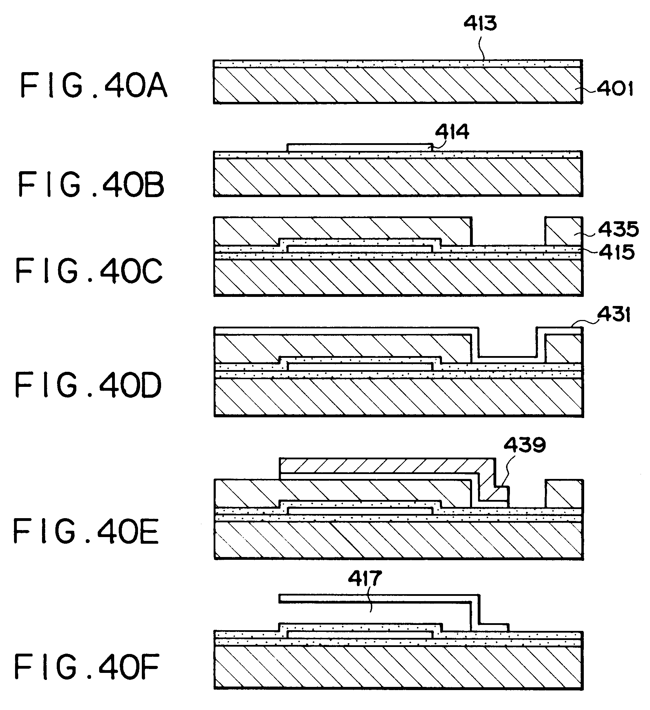

The steps in manufacturing the optical deflector according to this embodiment will be described with reference to Figs. 40A to 40F. A 3,000-Å thick silicon nitride film was formed on an Si substrate 401 by low-pressure CVD (LPCVD) (Fig. 40A). A 3,000-Å thick polysilicon film serving as a stationary electrode 414 was formed by LPCVD, and phosphorus (P) was ion-implanted at a dose of 1 x 10¹⁶ (ions/cm²) by the ion-implantation method and diffused in a nitrogen atmosphere at 1,100°C for an hour. As a result, the sheet resistance of the polysilicon film was 12 Ω/□. A photoresist was coated on the polysilicon film and patterned using a photolithographic process for performing exposure and development. A polysilicon pattern was formed using an aqueous solution mixture of hydrofluoric acid and nitric acid, and the resist pattern was removed to form the stationary electrode 414 (Fig. 40B).

A 1-µm thick silicon oxide film was formed on the resultant stationary electrode 414 by the sputtering method as one of the vacuum deposition methods, thereby forming a dielectric thin film layer 415. A 3-µm thick photoresist 435 was coated on the resultant structure by a spin coater to form a spacer layer (Fig. 40C). The photoresist 435-was partially removed by photolithography to form the contact portion of the mechanically movable portion (Fig. 40C). The photoresist was a positive photoresist (AZ1350J; tradename) available from Hoechst.

Aluminum (Al) was deposited using argon by the sputtering method to form a 3,000-Å thick Al thin film 431 on the photoresist. The temperature of the substrate holder was kept at 5°C in sputtering to suppress a heat stress in film formation. A photoresist 439 was coated and patterned by the photolithographic process. Al was then patterned by reactive ion etching (RIE) using an etching gas mixture of BCl₃ and Cl₂ to form a mechanically movable portion and a contact portion (Fig. 40E). Al on the step of the photoresist 435 in the contact portion became thin to be susceptible to deformation.

The photoresist on the Al and the photoresist under the mirror portion were etched and removed by RIE using an oxygen plasma, thereby forming a space 417. At this time, the etching conditions were set such oxygen was supplied at 100 ccm or more and the gas pressure was 20 Pa or more. These etching conditions were set for increasing the side-etching amount. In the resultant optical deflector, the mirror portion had a length of 42 µm and a width of 20 µm, as shown in Figs. 37 and 38.

In the optical deflector of this embodiment shown in Figs. 37, 38, and 39, as described above, when a voltage is not applied to the stationary electrode, a mirror portion 411 is not in contact with the dielectric thin film 415. When a voltage of 45 V is applied to the stationary electrode, the free end of the mirror portion is brought into contact with the dielectric thin film. When the voltage is further increased, the contact area increases accordingly. The contact distance (L) of the mirror portion at 100 V is about 30 µm, meaning about 1/3 of the total length of the mirror portion is in contact with the dielectric thin film. That is, with reference to Fig. 33, the deflection amount of light toward a reflecting direction Q₃ increases. The voltage at which the free end of the mirror portion is brought into contact with the dielectric thin film is defined as a bias voltage (45 V), and a drive voltage for adjusting the deflection light amount is superposed on this bias voltage to perform light amount adjustment in the reflecting direction Q₃ as in the previous embodiments.

In the above manufacturing process, the oxygen plasma is used to remove the photoresist as a space forming material. However, a solvent such as acetone may be used to dissolve the photoresist. The photoresist is used as the space forming material. However, a Ti thin film or a Ti/W metal alloy thin film may be formed by the vacuum deposition method such as the resistive heating deposition method or the electron beam deposition method, and the space forming material may be etched using a hydrogen peroxide solution in Fig. 40F, thereby forming the same optical deflector as in the above embodiments. In this embodiment, Al is used to form the mirror portion, but a semiconductor thin film such as silicon may be used. If an LPCVD silicon nitride film is used as the dielectric thin film and a silicon oxide film is used for the space forming material, a polysilicon film formed by LPCVD may be subjected to ion implantation to obtain a low-resistance polysilicon film which can be used as the mirror portion. That is, a metal, a semi-metal, and a low-resistance semiconductor, all of which can be exemplified by Al, Ag, Cu, Ga, Ge, In, and Si can be used if they allow removal of only the space forming material without etching the thin film materials for the mirror portion and the dielectric thin film in forming a space. As a thin film material used for a mirror, a material having a high reflectance may be selected depending on the wavelength of light to be deflected. Examples of the material for the mirror are a metal material (e.g., Ag, Al, Ni, Pt, Au, Cu, Ti, Co, or Zn) having a high reflectance in the range from the infrared region to the ultraviolet region. Such a metal material is not limited to an element itself, but can be an alloyed material consisting of two or more types of metal elements. The dielectric thin film is not limited to the silicon oxide and nitride films, but can be replaced with an electrical insulating material such as ZrO₂, Ta₂O₅, MgO, Al₂O₃, SiC, SiON, AlN, or ZnO.

In the manufacturing process described above, polysilicon is used as a material for the stationary electrode, but a metal material which is free from film damage due to heat or mechanical stress of the stationary electrode under the conditions for forming the dielectric thin film and the mirror portion may be used as the material for the stationary electrode. To reduce the drive voltage for adjusting the deflection light amount, a material having a large dielectric constant is used. That is, since the electrostatic attraction force generated when the mirror portion is brought into contact with the dielectric thin film layer is proportional to the dielectric constant, use of an insulating thin film layer material having a large dielectric constant can reduce the drive voltage for adjusting the deflection light amount as in the above embodiments. A ferroelectric material may be any material capable of forming a thin film, such as TiBaO, PbZrTiO, or PbTiO.

An organic polymer thin film may be used as the dielectric thin film on the stationary electrode. When a photoresist is used as a space forming material, for example, a silicon oxide which prevents oxygen plasma etching of the organic polymer thin film in formation of the space below the mirror portion and the beams may be formed to use the organic polymer thin film as the dielectric thin film. The organic polymer thin film can consist of polyimide, polyamide, or PMMA having insulating properties. A ferroelectric polymer material such as PVDF or P(VDF-TrFE) can be used to reduce the drive voltage as in the previous embodiment.

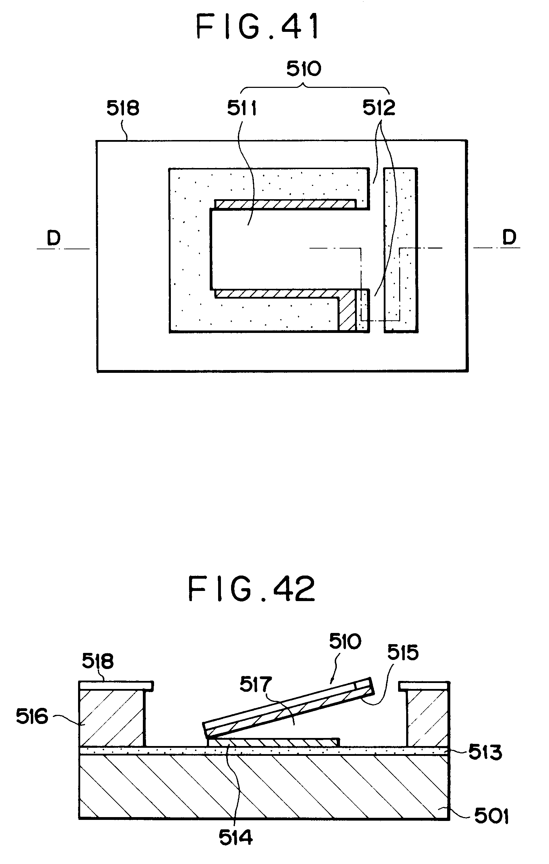

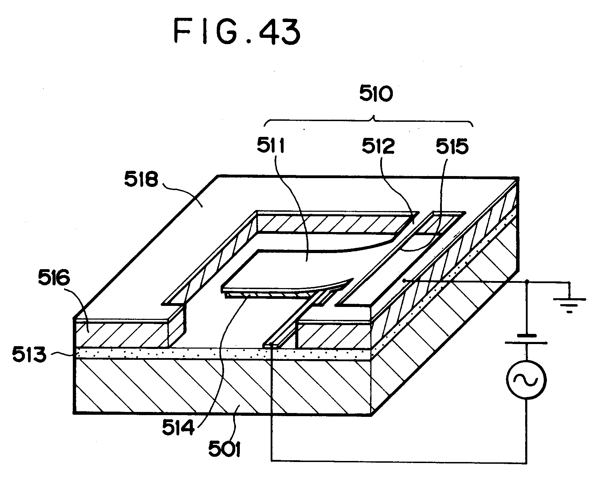

The eighth embodiment of an optical deflector according to the present invention is shown in Figs. 41 and 42. Unlike the fifth embodiment shown in Fig. 30, a flat dielectric thin film layer 515 is formed on the lower surface of a mirror portion 511 in this embodiment. An operation is substantially the same as that of the fifth embodiment if electric connections are made as shown in Fig. 43, and a detailed description thereof will be omitted.

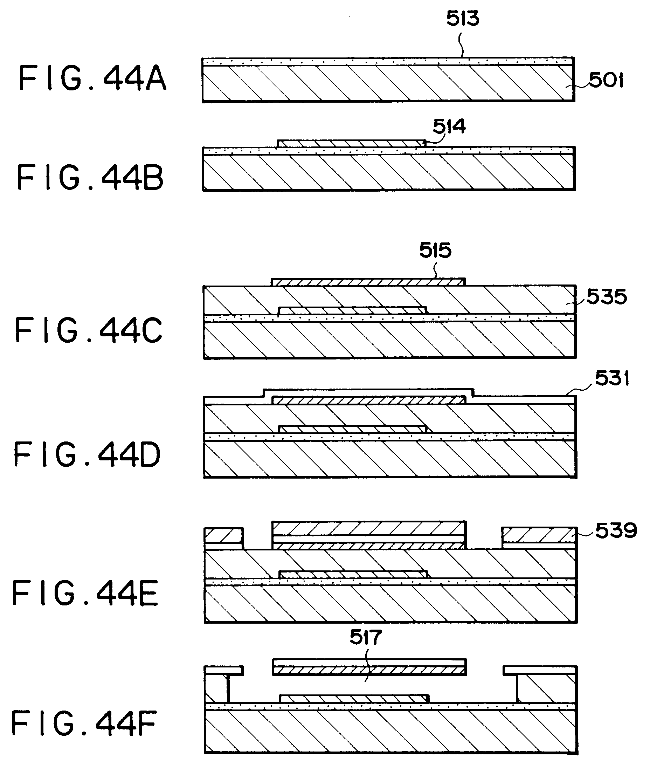

The steps in manufacturing the optical deflector according to this embodiment will be described with reference to Figs. 44A to 44F. A 1,500-Å thick silicon nitride film was formed on an Si substrate 501 by low-pressure CVD (LPCVD) to form an insulating film 513 (Fig. 44A). A 1,500-Å thick polysilicon film serving as a stationary electrode 514 was formed by LPCVD, and phosphorus (P) was ion-implanted at a dose of 1 x 10¹⁶ (ions/cm²) in accordance with the ion-implantation method and diffused in a nitrogen atmosphere at 1,100°C for an hour. The resultant polysilicon film had a sheet resistance of 12 Ω/□.

A photoresist was coated on the polysilicon film and patterned using a photolithographic process for performing exposure and development. A polysilicon pattern was formed using an aqueous solution mixture of hydrofluoric acid and nitric acid, and the resist pattern was removed to form the stationary electrode 514 (Fig. 44B).

A 3-µm thick photoresist 535 was coated on the resultant structure by a spin coater to form a spacer layer (Fig. 44C). The photoresist was a positive photoresist (AZ1350J; tradename) available from Hoechst. A 0.5-µm thick silicon oxide film was formed on the photoresist 535 by the sputtering method as one of the vacuum deposition methods to form a dielectric thin film 515. The temperature of the substrate in sputtering was set at 5°C to prevent heat damage to the photoresist in film formation and suppress a heat stress of the silicon oxide film. Although not shown, a photoresist was patterned by the same photolithography as patterning of the polysilicon film to etch and remove a portion except for the silicon oxide film serving as the dielectric thin film portion 515 for the mirror portion, using an aqueous hydrofluoric acid solution, thereby forming a pattern shown in Fig. 44C. In the electric conductor thin film serving as the mirror portion and the beams, aluminum (Al) was sputtered by the sputtering method using argon to deposit a 3,000-Å thick Al thin film 531. The temperature of the substrate holder in sputtering was set at 5°C which was equal to that in formation of the silicon oxide film, thereby suppressing the heat stress in film formation.

A photoresist 539 was coated on the resultant structure and patterned by the photolithographic process, and Al was patterned by reactive ion etching (RIE) using an etching gas mixture of BCl₃ and Cl₂ to form a mechanically movable portion and a contact portion (Fig. 44E). Thereafter, the photoresist on the Al and the photoresist below the mirror portion and the beams were etched and removed by RIE using an oxygen plasma to form a space 517. At this time, the etching conditions were set such oxygen was supplied at 100 ccm or more and the gas pressure was 20 Pa or more. These etching conditions were set for increasing the side-etching amount. By the above manufacturing steps, an optical deflector shown in Fig. 44F was obtained. In the resultant optical deflector, the mirror portion had a length of 42 µm and a width of 20 µm, as shown in Fig. 41.

In the manufacturing processes in Figs. 44A to 44F, the dielectric thin film is formed under the mirror portion but not under the beams. However, a two-layered structure consisting of the dielectric thin film and the electric conductor thin film may constitute the beams as in the mirror portion. In this case, the dielectric thin film 515 in Fig. 44C need not be patterned. After the Al thin film 531 is etched in Fig. 44E, the gas type is changed to the one (e.g., CF₄ or CHF₃) for relatively efficiently etching a silicon oxide film, and RIE can be similarly performed. When each beam is constituted by the two-layered structure, a voltage V_{b} required for distorting and rotating the beams to bring the free end of the mirror portion into contact with the stationary electrode increases because the secondary moments on the cross-section of the beam increase.

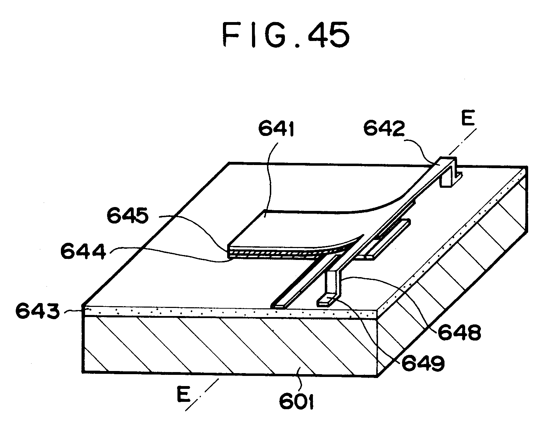

Fig. 45 is a view showing the ninth embodiment of an optical deflector according to the present invention. In this embodiment, in place of the support portion 318 of the embodiment in Fig. 30, contact portions 649 and support portions 648 for connecting the contact portions 649 to beams 642 are formed on a substrate. A voltage for operating the optical deflector is applied between a stationary electrode 644 and the contact portions 649. Referring to Fig. 45, the contact portions 649 are formed on an insulating layer 643. However, when the substrate is to be electrically grounded, windows for the contact portions may be formed in the insulating layer to electrically connect the contact portions to the substrate.

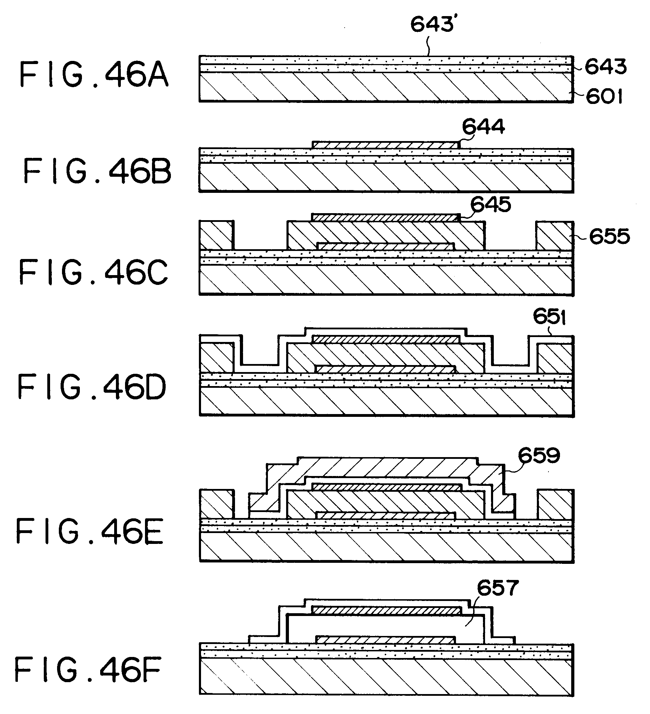

The steps in manufacturing the optical deflector according to this embodiment will be described with reference to Figs. 46A to 46F. An Si substrate 601 was loaded in an oxidation furnace heated to 1,100°C, and an oxidation gas mixture of oxygen and hydrogen was supplied thereto to form a 1-µm thick thermal silicon oxide film 643. A 3,000-Å thick silicon nitride film 643' was formed by low-pressure CVD (LPCVD), and insulating layers 643 and 643' consisting of a thermal silicon oxide film and a silicon nitride film were formed (Fig. 46A). To increase the adhesion properties between the silicon nitride film and the substrate, a silicon nitride film was formed therebetween. Since the insulating film had a two-layered structure, peeling and cracks of the silicon nitride film in annealing in the subsequent process and removal of the spacers consisting of the silicon oxide film can be prevented. A 1,500-Å thick polysilicon film serving as a stationary electrode 644 was formed by LPCVD at 620°C, and phosphorus (P) was ion-implanted at a dose of 1 x 10¹⁶ (ions/cm²) in accordance with the ion-implantation method and diffused in a nitrogen atom at 1,100°C for an hour. As a result, the sheet resistance of the resultant polysilicon film was 12 Ω/□. A photoresist was coated on this polysilicon film and patterned by the photolithographic process for performing exposure and development, and polysilicon was patterned by reactive ion etching (RIE) using an etching gas as CF₄. Thereafter, the resist was etched to form a stationary electrode 644 (Fig. 46B).

A 3-µm thick silicon oxide film 655 which would be finally removed to form a space was formed on the resultant stationary electrode 644 by the sputtering method as one of the vacuum deposition methods. The silicon oxide film 655 was partially removed by photolithography to form the contact portions of the mechanically movable portion (Fig. 46C). The silicon oxide film was etched using an aqueous solution mixture of hydrofluoric acid and ammonium fluoride and a resist mask. A 3,000-Å thick silicon nitride film formed by LPCVD to have a small stress was used as a dielectric thin film 645. The film formation conditions for this silicon nitride film were given such that the film formation gas was dichlorosilane (SiH₂Cl₂) supplied at 20 ccm, ammonia (NH₃) was supplied at 5 ccm, and the film formation temperature was 850°C. At this time, the stress was a compressive stress of 1.5 x 10⁸ dyn/cm², and patterning was performed using the same method for polysilicon constituting the stationary electrode. A polysilicon film was used as an electric conductor thin film serving as the mirror portion, the support portions and the beams. A 3,000-Å thick polysilicon film 651 was formed by LPCVD at 600°C, and phosphorus (P) was ion-implanted at a dose of 1 x 10¹⁶ (ions/cm²) in accordance with the ion-implantation method and diffused in a nitrogen atmosphere at 1,100°C for three hours. As a result, the stress of the polysilicon film was a compressive stress of 1.2 x 10⁸ dyn/cm² (Fig. 46D). In this patterning, a photoresist 659 was patterned by photolithography in accordance with the same etching method as in the polysilicon serving as the stationary electrode. Finally, the silicon oxide film 655 formed by the sputtering method was etched and removed using an aqueous hydrofluoric acid solution to form a space 657 shown in Fig. 46F.

The optical deflector shown in Fig. 45 was manufactured in the above manufacturing steps. The size of the mirror portion was equal to that of the embodiment in Fig. 41. When a voltage was not applied to the stationary electrode, the free end of the mirror portion was not brought into contact with the stationary electrode, and the mirror portion warped upward above the substrate by 1 µm with respect to the beams. When a voltage of 100 V was applied between the stationary electrode 644 and the contact portions 649, the mirror portion was brought into contact with the stationary electrode, and their contact distance L was 15 µm. In the optical deflector of this embodiment, even if the mirror portion warps due to a film stress difference in the two-layered structure of the dielectric thin film and the electric conductor thin film, light can be stably deflected toward a reflecting direction Q₃ in Fig. 33. In the optical deflector of this embodiment, even if the mirror portion warps due to a difference thermal expansion coefficient of the two-layered structure upon an increase in temperature of the optical deflector, the deflection operation is not adversely affected.

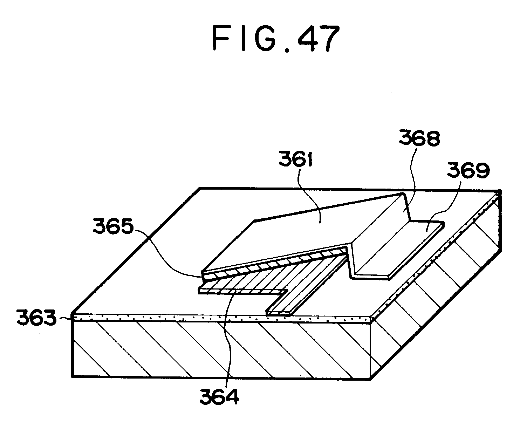

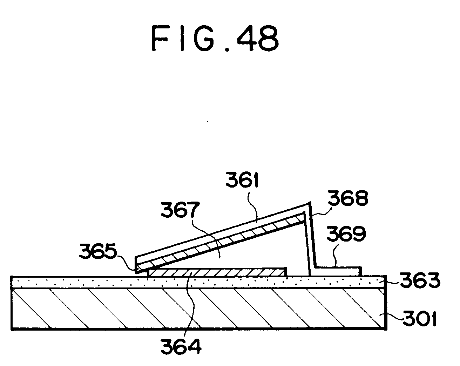

Fig. 47 is a perspective view showing the tenth embodiment of an optical deflector according to the present invention, and Fig. 48 is a sectional view showing the embodiment in Fig. 47. A stationary electrode is formed on a substrate through an insulating layer 363, and a support portion 368 fixed on the substrate by a contact portion 369 and a cantilevered mechanically movable portion consisting of a dielectric thin film 365 and a mirror portion 361 are formed through a space 367. Except for a structure in which the mirror portion 361 is supported by the support portion 368, the same deflection operation as in the embodiments of Figs. 41 and 45 can be performed such that a voltage is applied between a stationary electrode 364 and the contact portion 369. The optical deflector of this embodiment can be manufactured in the same manner as in the embodiment of Fig. 45.

In the embodiment of Fig. 45, the silicon oxide film serving as the space forming material is used. As in the embodiment of Fig. 41, the oxygen plasma is used to remove the photoresist as a space forming material. However, a solvent such as acetone may be used to dissolve the photoresist. In addition, the photoresist and the silicon oxide film are used as the space forming materials throughout the previous embodiments. However, as another space forming material, a Ti thin film or a Ti/W metal alloy thin film may be formed by the vacuum deposition method such as the resistive heating deposition method or the electron beam deposition method, and the space forming material may be etched using a hydrogen peroxide solution in Figs. 44A to 44F and 46, thereby forming the same optical deflector as in the above embodiments. Al and the ion-implanted low-resistance polysilicon film are used as the electric conductor thin films. However, a metal, a semi-metal, and a low-resistance semiconductor, all of which can be exemplified by Al, Ag, Cu, Ga, Ge, In, and Si can be used if they allow removal of only the spatial material without etching the thin film materials for the mirror portion and the dielectric thin film in etching the space forming material.

As a thin film material used for a mirror portion, a material having a high reflectance may be selected depending on the wavelength of light to be deflected. Examples of the material for the mirror are a metal material (e.g., Ag, Al, Ni, Pt, Au, Cu, Ti, Co, or Zn) having a high reflectance in the range from the infrared region to the ultraviolet region. Such a metal material is not limited to an element itself, but can be an alloyed material consisting of two or more types of metal elements. The dielectric thin film is not limited to the silicon oxide and nitride films, but can be replaced with an electrical insulating material such as ZrO₂, Ta₂O₅, MgO, Al₂O₃, SiC, SiON, AlN, or ZnO. In the manufacturing process described above, polysilicon is used as a material for the stationary electrode, but a metal material which is free from film damage due to heat or mechanical stress of the stationary electrode under the conditions for forming the dielectric thin film and the mirror portion may be used as the material for the stationary electrode.

To reduce the drive voltage for adjusting the deflection amount, a material having a large dielectric constant is used as described above. That is, since the electrostatic attraction force generated when the mirror portion is brought into contact with the dielectric thin film layer is proportional to the dielectric constant, use of an insulating thin film layer material having a large dielectric constant can reduce the drive voltage for adjusting the deflection light amount.

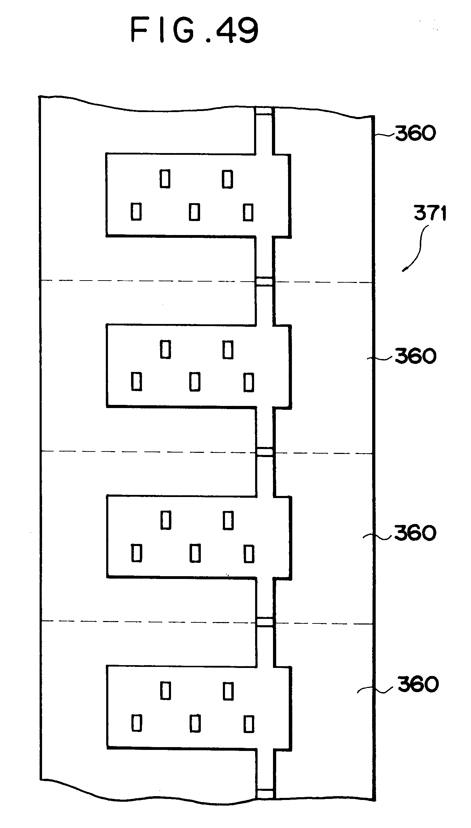

An embodiment of an image display device according to the present invention in which the optical deflectors each shown in Fig. 36 are used will be described with reference to Fig. 49. In an image display device 371 of this embodiment, a plurality of optical deflectors 360 shown in Fig. 36 are arranged such that their beams 342 are adjacent to each other. In this case, the substrates and the respective layers of all the optical deflectors can be integrally formed. In the respective optical deflectors 360 in the image display device 371 in which the mirrors are formed on a single substrate to constitute a micro-mirror array, stationary electrodes (not shown in Fig. 49) are located below the mirror portions, and the individual optical deflectors can independently control the deflection states and deflection light amounts.

An application of the image display device 371 to electrostatic printing is the same as that described with reference to Fig. 24. Light from a light source 212 is radiated on the image display device 371 through a lens 213. Since voltages are independently applied to the respective stationary electrodes of the optical deflectors 360 in accordance with image information, incident light beams are deflected to a lens 214 through the corresponding mirror portions, and the deflected light is focused on a photosensitive drum 215. Image formation by electrostatic printing is performed in the same manner as in the conventional case. In the image display device 371 of this embodiment, the contact area between the mirror portion and the dielectric thin film is changed to change the deflection light amount. That is, the mirror area is modulated to adjust the area of light focused on the photosensitive drum. Therefore, an area gradation expression in units of pixels of the mechanical optical deflectors, which was difficult in the prior art, can be attained.

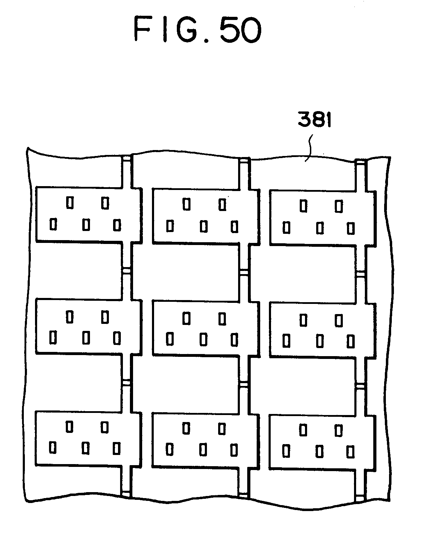

As shown in Fig. 50, it is possible to form an image display device 381 by arranging optical deflectors of the present invention in which the optical deflectors such shown in Fig. 36 are used two-dimensionally on a substrate, thereby applying the deflector to a projection display. An optical system obtained when the image display device of the present invention is applied to the projection display is the same as that shown in Fig. 27. Of the light from an illumination system 242, desired image data is reflected by each mirror portion and projected on a screen 245 through a projection lens 243 and a stop 244. When an image is not be displayed, light is reflected toward a light-shielding plate 246 by adjusting the mirror angles (i.e., a reflecting direction Q₄ in Fig. 33).

A projection display having one pixel corresponding to one mirror can be arranged using the image display device having the optical deflectors in Fig. 50. In order to display the image data formed by this image display device in the form of a color image, three optical systems and three image display devices, each shown in Fig. 27, are arranged, and R, G, and B color filters consisting of different color agents are arranged in front or behind the respective image display devices 381. Images from the respective image display devices are projected on a single screen, thereby displaying a full-color image. A color filter 247 consisting of a tricolor (RGB) filter (Fig. 28) is arranged in front of or behind the image display device along the optical path and is rotated about a rotating shaft 248 to obtain a color image (Fig. 29). In this case, the image display device forms an image synchronously and independently with respect to the color components. In the optical system shown in Fig. 27, the three image display devices are required. However, a color projection display can be manufactured using one image display device.

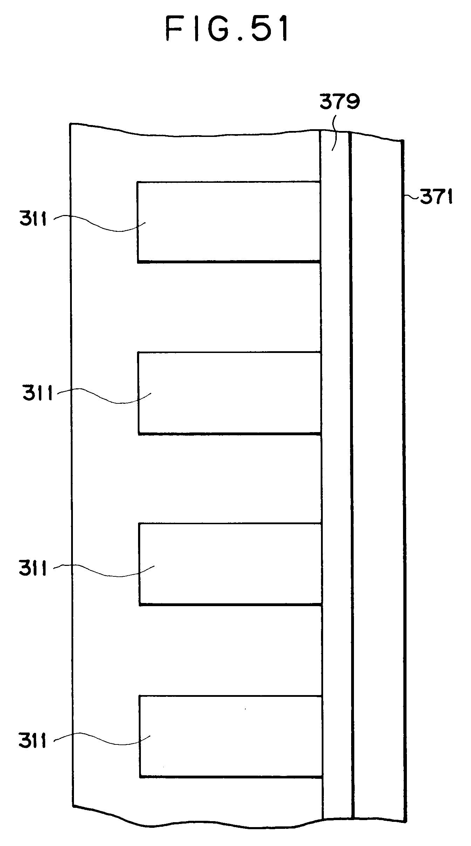

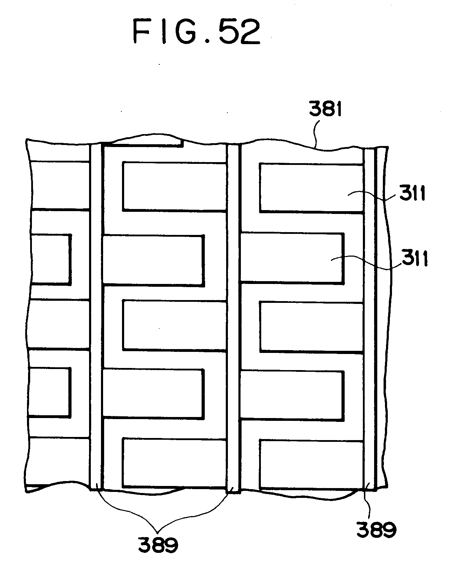

Fig. 51 shows another embodiment of an image display device according to the present invention. This image display device is arranged by arraying a plurality of optical deflectors each shown in Fig. 37. Fig. 52 shows an image display device in which the optical deflectors each shown in Fig. 37 are two-dimensionally staggered. A drive method and an application method of these devices are the same as in the embodiment of Fig. 49.

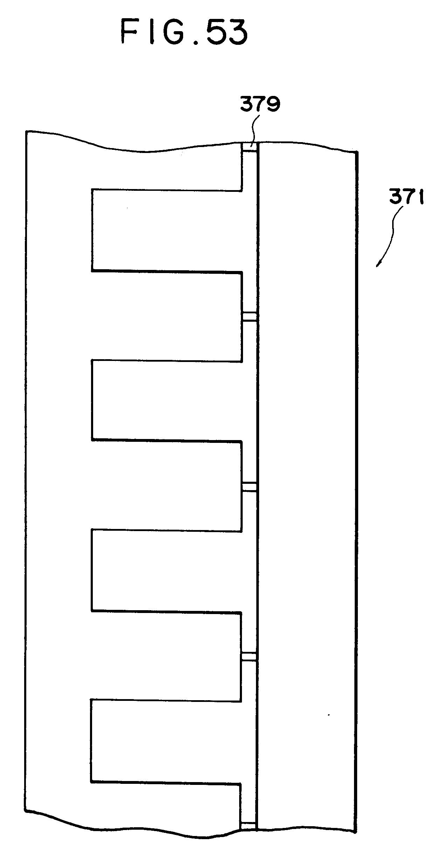

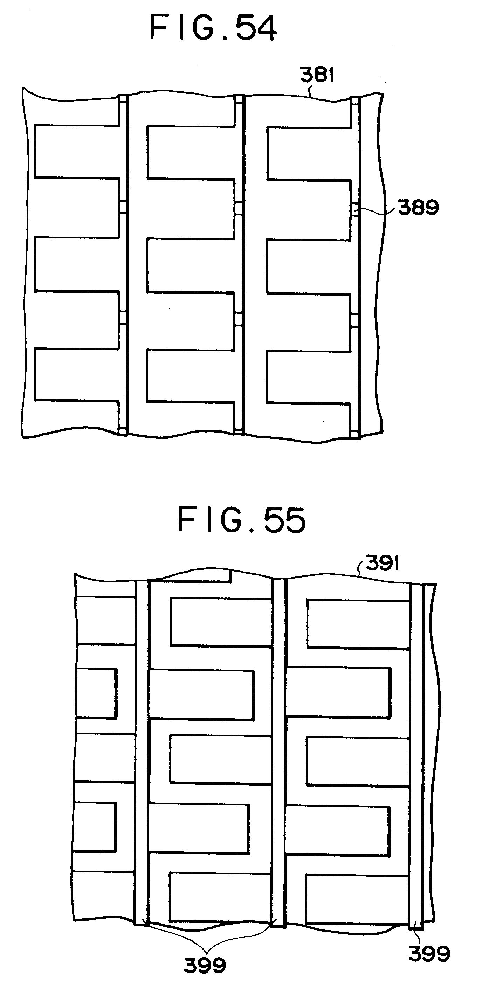

Fig. 53 shows still another embodiment of an image display device according to the present invention. This image display device is obtained by arraying a plurality of optical deflectors each shown in Fig. 45. Figs. 54 and 55 show image display devices obtained by two-dimensionally arraying pluralities of optical deflectors shown in Figs. 45 and 47, respectively. A drive method and an application method are the same as those in the embodiment of Fig. 50.

As has been described above, in an optical deflector according to the present invention, when a voltage is not applied between a stationary electrode 314 and a mirror portion 311 of the optical deflector, the mirror portion 311 is kept parallel to the stationary electrode 314. When a voltage application control unit applies a voltage corresponding to a desired amount of reflected light between the stationary electrode 314 and the mirror portion 311, the mirror member is attracted toward the stationary electrode and is brought into tight contact with a dielectric layer from the free end of the mirror member by an area corresponding to the desired amount of reflected light. Since a light beam is incident on the mirror member in tight contact with the dielectric layer, the light having an amount proportional to the contact area is deflected toward a light-receiving portion in a reflecting direction Q₃. In an image display device in which a plurality of optical deflectors are arrayed, an electrostatic voltage application control unit independently controls the respective optical deflectors to change the amount of reflected light from each optical deflector, thereby arbitrarily changing the gradation of an image to be displayed.

The optical deflector according to the present invention is arranged as described above and has the following effects:
(1) a mechanical, compact optical deflector array can be easily arranged;
(2) a reflecting optical deflector capable of adjusting the light amount can be provided; and
(3) a deflection angle error caused by warpage of the mirror surface caused by a film stress or the like can be prevented. That is, the mirror area can be changed. When this optical deflector is used in an image display device, an area gradation expression in units of pixels of an image can be realized. In the optical deflector according to the present invention, even if the thickness of a spacer changes, the optical deflector has a structure having good process reproducibility in the manufacture because light is deflected by the contact area between the mirror portion and the substrate to eliminate any deflection angle error.

In an optical deflector, a substrate has an upper surface with a stationary electrode. A mechanically movable portion is formed on the substrate through a space. The mechanically movable portion consists of an electric conductor and has an optical deflecting plate. A voltage is applied to the stantionary electrode. A groove for receiving a free end of the optical deflecting plate upon displacement of the mechanically movable portion is formed in the substrate. The mechanically movable portion has beams for supporting the optical deflecting plate.

## Claims

1. An optical deflector comprising:
a substrate having an upper surface with a stationary electrode;
a mechanically movable portion formed on said substrate through a space, said mechanically movable portion consisting of an electric conductor and having an-optical deflecting plate; and
means for applying a voltage to the stationary electrode,
wherein a groove for receiving a free end of the optical deflecting plate upon displacement of said mechanically movable portion is formed in said substrate.

2. A deflector according to claim 1, wherein said mechanically movable portion has beams, distorted to rotate, for supporting the optical deflecting plate.

3. A deflector according to claim 1, wherein the groove is a V-groove.

4. A deflector according to claim 3, wherein the stationary electrode is formed at one side of said V-groove.

5. A deflector according to claim 1, wherein the stationary electrode is formed at a portion of said substrate other than a groove.

6. A deflector according to claim 1, wherein a dielectric thin film is formed on the stationary electrode.

7. A deflector according to claim 6, wherein the optical deflecting plate is brought into surface contact with a surface of the dielectric thin film when the optical deflecting plate is displaced.

8. A deflector according to claim 1, wherein said mechanically movable portion has a support portion and a cantilevered plate through a contact portion at a portion of said substrate other than a groove, the cantilevered plate serving as the optical deflecting plate.

9. A deflector according to claim 1, wherein said mechanically movable portion comprises a flexible plate, an optical deflecting plate formed on one end face serving as a free end of the flexible plate, and a contact portion fixed on a portion of said substrate other than a groove.

10. A deflector according to claim 9, wherein the space comprises the groove.

11. A deflector according to claim 1, wherein the electric conductor comprises a metal thin film.

12. A deflector according to claim 1, using a plurality of optical deflectors each constituted by said optical deflector and comprising displacing means for displacing each of the plurality of optical deflectors independently of remaining ones of the plurality of optical deflectors to display an image.

13. A method of manufacturing an optical deflector on a substrate using a thin film forming method, comprising the steps of:
forming a groove in the substrate;
forming a stationary electrode on the substrate having the groove;
burying the groove with a burying material and flattening the resultant surface;
forming a mechanically movable portion having the optical deflecting plate on the flattened substrate; and
removing the burying material.

14. An optical deflector comprising:
a flat stationary electrode;
a dielectric layer formed to flatly cover one surface of said stationary electrode;
a mirror member made of a thin metal plate having elasticity;
a support member for supporting one end of said mirror member so as to oppose said mirror member at a predetermined spatial distance from said stationary electrode covered with said dielectric layer; and
a voltage application control unit for applying a predetermined voltage between said stationary electrode and said mirror member to attract said mirror member toward said stationary electrode, bringing said mirror member into tight contact with said dielectric layer from a free end of said mirror member.

15. An optical deflector comprising:
a flat stationary electrode;
a mirror member made of a thin metal plate having elasticity;
a dielectric layer formed to flatly cover one surface of said mirror member;
a support member for directing said one surface of said mirror member which is covered with said dielectric layer toward said stationary electrode and supporting one end of said mirror member so as to oppose said mirror member at a predetermined spatial distance from said stationary electrode; and
a voltage application control unit for applying a predetermined voltage between said stationary electrode and said mirror member to attract said mirror member toward said stationary electrode, bringing said mirror member covered with said dielectric layer into tight contact with said stationary electrode from a free end of said mirror member.

16. A mirror member according to claim 14 or 15, wherein part of mirror member constitutes beams, and said support portion supports said mirror member through the beam.

17. A deflector according to claim 16, wherein a width of the beam of said mirror member has a size so as to allow easy distortion of said beam and not to apply an undesirable a deformation force to the main part of said mirror member when said mirror member is attracted to said stationary electrode upon application of a voltage.

18. A deflector according to claim 16, wherein said stationary electrode is a metal layer formed on an insulating layer on a semiconductor substrate, said dielectric layer is a dielectric thin layer formed on the insulating layer so as to cover said stationary electrode, said support member comprise a spacer layer formed around said stationary electrode and a metal layer formed on an upper surface of the spacer layer and connected to a terminal end portion of the beam of said mirror member, and said mirror member is a metal layer formed in the same process as that of the metal layer of said support member.

19. A deflector according to claim 18, wherein said support member is bent at a right angle at a portion to which the beam extends by a predetermined distance, and is fixed on said substrate or said dielectric layer.

20. A deflector according to claim 14, wherein a shape of said stationary electrode is a rectangular, a shape of a main part of said mirror member is also rectangular, and one side of a rectangular shape of said mirror member is bent at a right angle and extends, and has a terminal end fixed on said dielectric layer, thereby constituting said support member.

21. A deflector according to claim 14 or 15, wherein said dielectric layer essentially consists of a ferroelectric material.

22. A deflector according to claim 14 or 15, wherein said dielectric layer comprises an organic polymer thin film.

23. A deflector according to claim 14 or 15, wherein said mirror member comprises an aluminum thin film.

24. A deflector according to claim 14, wherein the electrostatic voltage applied between said stationary electrode and said mirror member by the voltage application control unit comprises a bias voltage required for bringing the free end of said mirror member into contact with said dielectric layer and a drive voltage required for bringing part of said mirror member into tight contact with said dielectric layer.

25. A deflector according to claim 15, wherein the voltage applied between said stationary electrode and said mirror member by said voltage application control unit comprises a bias voltage required for bringing the free end of said mirror member covered with said dielectric layer into contact with said stationary electrode and a drive voltage required for bringing part of said mirror member covered with said dielectric layer into tight contact with said stationary electrode.

26. An image display device wherein a plurality of optical deflectors comprise said optical deflectors defined in claim 14 and are arranged on a single plane, and the voltage application control unit drives the plurality of optical deflectors independently, thereby displaying an image from reflected light from each optical deflector.

27. An image display device wherein a plurality of optical deflectors comprise said optical deflectors defined in claim 15 and are arranged on a single plane, and the voltage application control unit drives the plurality of optical deflectors independently, thereby displaying an image from reflected light from each optical deflector.
